# EUROPEAN PATENT SPECIFICATION

(11) **EP 4 306 315 B1**
(45) Date of publication and mention of the grant of the patent: **15.04.2026**
(21) Application number: 22774829.0
(22) Date of filing: 21.02.2022
(51) Int. Cl.: B32B 27/00, H01L 21/02, H01L 21/304, H01L 21/60, B32B 7/06

(54) **MULTILAYER BODY, METHOD FOR PRODUCING MULTILAYER BODY, AND METHOD FOR PRODUCING SEMICONDUCTOR SUBSTRATE**
MEHRSCHICHTKÖRPER, VERFAHREN ZUR HERSTELLUNG EINES MEHRSCHICHTKÖRPERS UND VERFAHREN ZUR HERSTELLUNG EINES HALBLEITERSUBSTRATS
CORPS MULTICOUCHE, PROCÉDÉ DE PRODUCTION DE CORPS MULTICOUCHE ET PROCÉDÉ DE PRODUCTION DE SUBSTRAT SEMI-CONDUCTEUR

(30) Priority: 26.03.2021 JP 2021053121
(43) Date of publication of application: 17.01.2024
(73) Proprietor: Nissan Chemical Corporation, Tokyo 103-6119 (JP)
(72) Inventor: YAGYU Masafumi, Toyama-shi, Toyama 939-2792 (JP); OGATA Hiroto, Toyama-shi, Toyama 939-2792 (JP); OKUNO Takahisa, Toyama-shi, Toyama 939-2792 (JP)
(74) Representative: Hoffmann Eitle
(86) International application number: PCT/JP2022/006804
(87) International publication number: WO 2022/202029

(56) References cited:
- WO-A1-2015/146950
- WO-A1-2015/190438
- WO-A1-2018/216732
- WO-A1-2020/138240
- GB-A- 2 530 388
- JP-A- 2013 179 135
- JP-A- 2017 073 541
- US-A1- 2016 375 652
- US-A1- 2017 200 628

## Description

### Technical Field

The present invention relates to a laminate, a method for manufacturing a laminate, and a method for manufacturing a semiconductor substrate.

### Background Art

For a semiconductor wafer that has been integrated in a two-dimensional planar direction in the related art, there is a demand for a semiconductor integration technique that integrates (laminates) planes in a three-dimensional direction for the purpose of further integration. The three-dimensional lamination is a technique of laminating layers into a multi-layer while connecting the layers by a through-silicon via (TSV). At the time of multi-layer lamination, each of wafers to be integrated is thinned by polishing on a side opposite to the formed circuit surface (that is, a rear surface), and the thinned semiconductor wafers are laminated.

In order to polish a semiconductor wafer before thinning (also simply referred to herein as a "wafer") with a polishing device, the semiconductor wafer adheres to a support.

The adhesion at that time is referred to as temporary adhesion because it should be easily peeled off after polishing. This temporary adhesion should be easily removed from the support, and the thinned semiconductor wafer may be cut or deformed when a large force is applied for removal. Therefore, the semiconductor wafer is easily removed so that such a situation does not occur. However, at the time of polishing the rear surface of the semiconductor wafer, it is not preferable that the semiconductor wafer is detached or displaced due to a polishing stress. Therefore, the performance required for the temporary adhesion is to withstand the stress during polishing and to be easily removed after polishing.

For example, there is a demand for performance having a high stress (strong adhesive force) in a planar direction at the time of polishing and a low stress (weak adhesive force) in a longitudinal direction at the time of removal.

As such an adhesion process, there has been proposed a wafer support structure including, between a wafer (1) that is a semiconductor wafer and a support layer (6) that is a support, a silicone oil layer, a separation layer (4) that is a plasma polymer layer, and a layer (5) of a partially cured or curable elastomer material from the wafer (1) side, in which an adhesive bond between a support layer system and the separation layer (4) after the elastomer material is completely cured is larger than an adhesive bond between the wafer (1) and the separation layer (4) (for example, see Examples of Patent Literature 1).

There is a constant demand for a technology that can easily remove a semiconductor wafer from a support without requiring a large force for removal when the thinned semiconductor wafer is removed from the support after the semiconductor wafer is thinned.

In addition, the semiconductor wafer is electrically connected to a semiconductor chip via a bump ball formed of, for example, a metal conductive material, and miniaturization of semiconductor packaging is achieved by using a chip including such a bump ball.

A bump ball formed of a metal such as copper or tin may be damaged or deformed by external loads such as heating and pressure applied in a process of processing a semiconductor substrate or the like, and in accordance with recent progress in the semiconductor field, a technique capable of reducing or preventing such deformation due to heating or pressure is always required.

Furthermore, JP 2013-179135 A describes a wafer processing body where a temporary adhesive layer is formed on a support, and a wafer having a circuit surface on the front surface and the back surface to be processed is laminated on the temporary adhesive layer. The temporary adhesive layer includes a first temporary adhesive layer consisting of a non-aromatic saturation hydrocarbon-containing organopolysiloxane polymer layer (A), and a second temporary adhesive layer laminated on the first temporary adhesive layer and consisting of a thermosetting modified siloxane polymer layer (B) bonded peelably to the support.

US 2017/200628 A1 relates to a layered body for processing a rear surface of a wafer opposite to a circuit surface of the wafer. The layered body is a temporary adhesive loaded between a support and circuit surface of the wafer and including an adhesive layer (A) that includes a polyorganosiloxane to be cured by a hydrosilylation reaction and is releasably bonded, and a separation layer (B) which includes a polyorganosiloxane and is releasably bonded. The polyorganosiloxane forming the separation layer (B) is a polyorganosiloxane containing a siloxane unit of RRSiO_{2/2}, provided that each R is bonded to a silicon atom as a Si-C bond, and at least one R is an aralkyl group, epoxy group, or phenyl group.

GB 2530388 A is concerned with a temporary bonding adhesive composition comprising a fluoro-containing silicone.

US 2016/375652 A1 describes a stack including a substrate material temporarily fixed on a support via a temporary fixing material. The temporary fixing material includes a temporary fixing material layer (I) in contact with the support-facing surface of the substrate material, and a temporary fixing material layer (II) formed on the support-facing surface of the layer (I). The temporary fixing material layer (I) is formed of a temporary fixing composition containing a polymer (A) and a release agent (B) which contains a functional group capable of reacting with the polymer (A) to form a chemical bond.

WO 2015/146950 A1 inter alia describes a composition for forming a protective layer and a laminate which has a protective layer that is obtained using this composition. The composition for forming a protective layer for bonding a wafer and a supporting substrate with each other contains a resin having a melt flow rate of 4-150 g/10 min or less at 200C under a load of 10 kg in accordance with JIS K-7210.

### Citation List

### Patent Literature

Patent Literature 1: JP 5335443 B2

### Summary of Invention

### Technical Problem

The present invention has been made in view of the circumstances described above, and an object of the present invention is to provide a laminate including an adhesive layer capable of easily peeling a semiconductor substrate and a support substrate and suppressing deformation of a bump, a method for manufacturing a semiconductor substrate using the laminate, and a method for manufacturing the laminate.

### Solution to Problem

As a result of conducting intensive studies to solve the problems described above, the present inventors have completed the present invention. The present invention provides a laminate, a method for manufacturing a laminate, and a method for manufacturing a semiconductor substrate according to the appended claims.

That is, the present invention provides the following.

A laminate including: a semiconductor substrate with a bump; a support substrate; a protective adhesive layer formed so as to be in contact with the semiconductor substrate with a bump; and a peeling adhesive layer formed between the protective adhesive layer and the support substrate,
in which the protective adhesive layer is formed of a protective adhesive composition, and the protective adhesive composition contains a component (A) which is cured by a hydrosilylation reaction and does not contain a peeling agent component (B) which does not cause a curing reaction together with the component (A),
the peeling adhesive layer is formed of a peeling adhesive composition, and the peeling adhesive composition contains a component (A) which is cured by a hydrosilylation reaction and a peeling agent component (B) which does not cause a curing reaction together with the component (A),
the component (A) contained in the protective adhesive composition contains a polyorganosiloxane (a1) containing an alkenyl group having 2 to 40 carbon atoms bonded to silicon atoms, a polyorganosiloxane (a2) containing a Si-H group, and a platinum group metal-based catalyst (A2),
the component (A) contained in the peeling adhesive composition contains a polyorganosiloxane (a1) containing an alkenyl group having 2 to 40 carbon atoms bonded to silicon atoms, a polyorganosiloxane (a2) containing a Si-H group, and a platinum group metal-based catalyst (A2), and
the peeling agent component (B) contained in the peeling adhesive composition is a polyorganosiloxane selected from an epoxy group-containing polyorganosiloxane, a methyl group-containing polyorganosiloxane, and a phenyl group-containing polyorganosiloxane.

A method for manufacturing a semiconductor substrate, the method including:
a step of processing the semiconductor substrate in the laminate according to the present invention; and
a step of separating the support substrate and the processed semiconductor substrate by separating the protective adhesive layer and the peeling adhesive layer.

A method for manufacturing the laminate according to the present invention, the method including:
a protective adhesive coating layer formation step of forming a protective adhesive coating layer by applying a protective adhesive composition onto a surface of the semiconductor substrate on which the bump exists;
a protective adhesive layer formation step of forming the protective adhesive layer by heating the protective adhesive coating layer;
a peeling adhesive coating layer formation step of forming a peeling adhesive coating layer by applying a peeling adhesive composition onto the support substrate or applying the peeling adhesive composition onto the protective adhesive layer; and
a peeling adhesive layer formation step of forming the peeling adhesive layer by heating the peeling adhesive coating layer in a state in which the peeling adhesive coating layer and the protective adhesive layer are in contact with each other and the peeling adhesive coating layer and the support substrate are in contact with each other, wherein
the protective adhesive composition contains a component (A) which is cured by a hydrosilylation reaction and does not contain a peeling agent component (B) which does not cause a curing reaction together with the component (A),
the peeling adhesive composition contains a component (A) which is cured by a hydrosilylation reaction and a peeling agent component (B) which does not cause a curing reaction together with the component (A),
the component (A) contained in the protective adhesive composition contains a polyorganosiloxane (a1) containing an alkenyl group having 2 to 40 carbon atoms bonded to silicon atoms, a polyorganosiloxane (a2) containing a Si-H group, and a platinum group metal-based catalyst (A2),
the component (A) contained in the peeling adhesive composition contains a polyorganosiloxane (a1) containing an alkenyl group having 2 to 40 carbon atoms bonded to silicon atoms, a polyorganosiloxane (a2) containing a Si-H group, and a platinum group metal-based catalyst (A2), and
the peeling agent component (B) contained in the peeling adhesive composition is a polyorganosiloxane selected from an epoxy group-containing polyorganosiloxane, a methyl group-containing polyorganosiloxane, and a phenyl group-containing polyorganosiloxane.

### Advantageous Effects of Invention

According to the present invention, it is possible to provide a laminate including an adhesive layer capable of easily peeling a semiconductor substrate and a support substrate and suppressing deformation of a bump, a method for manufacturing a semiconductor substrate using the laminate, and a method for manufacturing the laminate.

### Brief Description of Drawings

Fig. 1 is a schematic cross-sectional view of an example of a laminate.
Fig. 2A is a view (part 1) for explaining an aspect in which a laminate is manufactured and a thinned wafer is manufactured.
Fig. 2B is a view (part 2) for explaining an aspect in which a laminate is manufactured and a thinned wafer is manufactured.
Fig. 2C is a view (part 3) for explaining an aspect in which a laminate is manufactured and a thinned wafer is manufactured.
Fig. 2D is a view (part 4) for explaining an aspect in which a laminate is manufactured and a thinned wafer is manufactured.
Fig. 2E is a view (part 5) for explaining an aspect in which a laminate is manufactured and a thinned wafer is manufactured.
Fig. 2F is a view (part 6) for explaining an aspect in which a laminate is manufactured and a thinned wafer is manufactured.
Fig. 2G is a view (part 7) for explaining an aspect in which a laminate is manufactured and a thinned wafer is manufactured.
Fig. 2H is a view (part 8) for explaining an aspect in which a laminate is manufactured and a thinned wafer is manufactured.

### Mode for Carrying Out the Invention

### (Laminate)

A laminate of the present invention includes a support substrate, a semiconductor substrate, a protective adhesive layer, and a peeling adhesive layer.

The semiconductor substrate has bumps on a side of the support substrate.

The protective adhesive layer is interposed between the support substrate and the semiconductor substrate.

The protective adhesive layer is in contact with the semiconductor substrate.

The peeling adhesive layer is interposed between the support substrate and the protective adhesive layer.

The peeling adhesive layer is preferably in contact with the support substrate and the protective adhesive layer.

The laminate is used for an application in which the support substrate and the semiconductor substrate are separated after processing of the semiconductor substrate in the laminate.

In the laminate, the protective adhesive layer is formed in contact with the semiconductor substrate, such that it is possible to suppress deformation of the bump when manufacturing a processed semiconductor substrate. This is considered to be because the bump that is likely to be melted or deformed by heat and pressure during processing of the semiconductor substrate is protected by the protective adhesive layer that is less likely to be melted and deformed, and as a result, the shape of the bump is maintained.

In addition, since the peeling adhesive layer is formed between the support substrate and the protective adhesive layer in the laminate, two substrates can be preferably separated without applying an excessive load to the substrates when the support substrate and the semiconductor substrate are separated. This is considered that since the peeling adhesive layer contains a peeling agent component as described below, when the substrates are separated from each other, peeling in the peeling adhesive layer or at an interface between the peeling adhesive layer and a layer adjacent thereto or the substrate can be selectively realized well, and as a result, an excessive load on the substrate can be avoided.

### <Support Substrate>

The support substrate is not particularly limited as long as it is a member capable of supporting the semiconductor substrate when the semiconductor substrate is processed, and examples thereof include a glass support substrate and a silicon support substrate.

A shape of the support substrate is not particularly limited, and examples thereof include a disk shape. Note that the disk-shaped support substrate does not need to have a completely circular surface shape, and for example, an outer periphery of the support substrate may have a straight portion called an orientation flat or may have a cut called a notch.

A thickness of the disk-shaped support substrate may be appropriately determined according to a size of the semiconductor substrate and the like, and is not particularly limited, but is, for example, 500 to 1,000 µm.

A diameter of the disk-shaped support substrate may be appropriately determined according to the size of the semiconductor substrate and the like, and is not particularly limited, but is, for example, 100 to 1,000 mm.

An example of the support substrate is a glass wafer or a silicon wafer having a diameter of 300 mm and a thickness of about 700 µmm.

### <Semiconductor Substrate>

The semiconductor substrate has bumps. The bump is a protruding terminal.

In the laminate, the semiconductor substrate has bumps on a side of the support substrate.

In the semiconductor substrate, the bump is usually formed on a surface on which a circuit is formed. The circuit may be a single layer or may be a multi-layer. A shape of the circuit is not particularly limited.

In the semiconductor substrate, a surface opposite to a surface having the bump (rear surface) is a surface to be processed.

A main material constituting the entire semiconductor substrate is not particularly limited as long as it is used for this type of application, and examples thereof include silicon, silicon carbide, and a compound semiconductor.

A shape of the semiconductor substrate is not particularly limited, and examples thereof include a disk shape. Note that the disk-shaped semiconductor substrate does not need to have a completely circular surface shape, and for example, an outer periphery of the semiconductor substrate may have a straight portion called an orientation flat or may have a cut called a notch.

A thickness of the disk-shaped semiconductor substrate may be appropriately determined according to a purpose of use of the semiconductor substrate and the like, and is not particularly limited, but is, for example, 500 to 1,000 µm.

A diameter of the disk-shaped semiconductor substrate may be appropriately determined according to a purpose of use of the semiconductor substrate and the like, and is not particularly limited, but is, for example, 100 to 1,000 mm.

An example of the semiconductor substrate is a silicon wafer having a diameter of 300 mm and a thickness of about 770 µm.

The material, size, shape, structure, and density of the bumps of the semiconductor substrate are not particularly limited.

Examples of the bump include a ball bump, a print bump, a stud bump, and a plating bump.

Usually, a height, diameter, and pitch of the bump are appropriately determined from conditions of a bump height of about 1 to 200 µm, a bump diameter of 1 to 200 µm, and a bump pitch of 1 to 500 µm.

Examples of the material of the bump include a solder having a low melting point, a solder having a high melting point, tin, indium, gold, silver, and copper. The bump may be formed of only a single component or may be formed of a plurality of components. More specific examples thereof include alloy plating mainly containing Sn, such as SnAg bumps, SnBi bumps, Sn bumps, or AuSn bumps.

In addition, the bump may have a laminated structure including a metal layer containing at least one of these components.

### <Protective Adhesive Layer>

The protective adhesive layer is interposed between the support substrate and the semiconductor substrate.

The protective adhesive layer is in contact with the semiconductor substrate.

The protective adhesive layer is formed of a protective adhesive composition, and the protective adhesive composition contains a component (A) which is cured by a hydrosilylation reaction and does not contain a peeling agent component (B) which does not cause a curing reaction together with the component (A).

Note that the peeling agent component (B) defined not to be contained in the protective adhesive composition is defined by comparison with a peeling agent component (B) defined to be contained in the peeling adhesive composition, and the detailed content of the peeling agent component (B) is described in the section of <<Peeling Adhesive Composition>> in <<Peeling Adhesive Layer>> described above.

### <<Protective Adhesive Composition>>

The protective adhesive composition contains a component (A) which is cured by a hydrosilylation reaction.

The protective adhesive composition used in the present invention contains a polyorganosiloxane.

In a preferred aspect, the protective adhesive composition used in the present invention contains a component (A) which is cured to be an adhesive component.

The component (A) is a polyorganosiloxane component (A') which is cured by a hydrosilylation reaction.

The component (A) contains a polyorganosiloxane (a1) containing an alkenyl group having 2 to 40 carbon atoms bonded to silicon atoms, a polyorganosiloxane (a2) containing a Si-H group, and a platinum group metal-based catalyst (A2). Here, the alkenyl group having 2 to 40 carbon atoms may be substituted. Examples of a substituent include a halogen atom, a nitro group, a cyano group, an amino group, a hydroxy group, a carboxyl group, an aryl group, and a heteroaryl group.

In a preferred aspect, the polyorganosiloxane component (A') which is cured by a hydrosilylation reaction contains a polysiloxane (A1) containing one or two or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}, and a platinum group metal-based catalyst (A2), and the polysiloxane (A1) contains one or two or more units selected from the group consisting of a siloxane unit (Q' unit) represented by SiO₂, a siloxane unit (M' unit) represented by R¹'R²'R³'SiO_{1/2}, a siloxane unit (D' unit) represented by R⁴'R⁵'SiO_{2/2}, and a siloxane unit (T' unit) represented by R⁶'SiO_{3/2}, contains a polyorganosiloxane (a1') containing at least one selected from the group consisting of an M' unit, a D' unit, and a T' unit, and one or two or more units selected from the group consisting of a siloxane unit (Q" unit) represented by SiO₂, a siloxane unit (M" unit) represented by R¹"R²"R³"SiO_{1/2}, a siloxane unit (D" unit) represented by R⁴"R⁵"SiO_{2/2}, and a siloxane unit (T" unit) represented by R⁶"SiO_{3/2}, and contains a polyorganosiloxane (a2') containing at least one selected from the group consisting of an M" unit, a D" unit, and a T" unit.

Note that (a1') is an example of (a1) and (a2') is an example of (a2).

R¹ to R⁶ are groups or atoms bonded to silicon atoms, and each independently represent an alkyl group which may be substituted, an alkenyl group which may be substituted, or a hydrogen atom. Examples of a substituent include a halogen atom, a nitro group, a cyano group, an amino group, a hydroxy group, a carboxyl group, an aryl group, and a heteroaryl group.

R¹' to R⁶' are groups bonded to silicon atoms, and each independently represent an alkyl group which may be substituted or an alkenyl group which may be substituted, but at least one of R¹' to R⁶' is an alkenyl group which may be substituted. Examples of a substituent include a halogen atom, a nitro group, a cyano group, an amino group, a hydroxy group, a carboxyl group, an aryl group, and a heteroaryl group.

R¹" to R⁶" are groups or atoms bonded to a silicon atom, and each independently represent an alkyl group which may be substituted or a hydrogen atom, but at least one of R¹" to R⁶" is a hydrogen atom. Examples of a substituent include a halogen atom, a nitro group, a cyano group, an amino group, a hydroxy group, a carboxyl group, an aryl group, and a heteroaryl group.

The alkyl group may be a linear, branched, or cyclic alkyl group, but is preferably a linear or branched alkyl group, and the number of carbon atoms thereof is not particularly limited, but is usually 1 to 40, preferably 30 or less, more preferably 20 or less, and still more preferably 10 or less.

Specific examples of the linear or branched alkyl group which may be substituted include, but are not limited to, a methyl group, an ethyl group, an n-propyl group, an i-propyl group, an n-butyl group, an i-butyl group, an s-butyl group, a tert-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n- butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, and more preferably 1 to 6. Among them, a methyl group is particularly preferable.

Specific examples of the cyclic alkyl group which may be substituted include, but are not limited to, cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group, and bicycloalkyl groups such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, and more preferably 5 or 6.

The alkenyl group may be a linear, branched, or cyclic alkenyl group, and the number of carbon atoms thereof is 2 to 40, preferably 30 or less, more preferably 20 or less, and still more preferably 10 or less.

Specific examples of the linear or branched alkenyl group which may be substituted include, but are not limited to, a vinyl group, an allyl group, a butenyl group, and a pentenyl group, and the number of carbon atoms thereof is usually 2 to 14, preferably 2 to 10, and more preferably 1 to 6. Among them, an ethenyl group and a 2-propenyl group are particularly preferable.

Specific examples of the cyclic alkenyl group which may be substituted include, but are not limited to, cyclopentenyl and cyclohexenyl, and the number of carbon atoms thereof is usually 4 to 14, preferably 5 to 10, and more preferably 5 or 6.

As described above, the polysiloxane (A1) contains a polyorganosiloxane (a1') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more kinds of polyorganosiloxanes satisfying such conditions may be used in combination.

Examples of preferred combinations of two or more selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, in a case where two or more kinds of polyorganosiloxanes contained in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but are not limited thereto.

The polyorganosiloxane (a2') contains one or two or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more kinds of polyorganosiloxanes satisfying such conditions may be used in combination.

Examples of preferred combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') is composed of siloxane units in which alkyl groups and/or alkenyl groups are bonded to silicon atoms thereof, and a ratio of alkenyl groups in all substituents represented by R¹' to R⁶' is preferably 0.1 to 50.0 mol%, and more preferably 0.5 to 30.0 mol%, and the remaining R¹' to R⁶' can be alkyl groups.

The polyorganosiloxane (a2') is composed of siloxane units in which alkyl groups and/or hydrogen atoms are bonded to silicon atoms thereof, and a ratio of hydrogen atoms in all substituents and substituent atoms represented by R^{1"} to R^{6"} is preferably 0.1 to 50.0 mol%, and more preferably 10.0 to 40.0 mol%, and the remaining R^{1"} to R^{6"} can be alkyl groups.

In a case where the component (A) contains (a1) and (a2), in a preferred aspect of the present invention, a molar ratio of the alkenyl group contained in the polyorganosiloxane (a1) and the hydrogen atom constituting the Si-H bond contained in the polyorganosiloxane (a2) is in a range of 1.0:0.5 to 1.0:0.66.

A weight average molecular weight of the polysiloxane such as the polyorganosiloxane (a1) or the polyorganosiloxane (a2) is not particularly limited, but is usually 500 to 1,000,000, and is preferably 5,000 to 50,000 from the viewpoint of realizing the effect of the present invention with excellent reproducibility.

Note that, in the present invention, a weight average molecular weight, a number average molecular weight, and a dispersity of the polyorganosiloxane can be measured, for example, using a GPC apparatus (manufactured by Tosoh Corporation, EcoSEC or HLC-8320GPC) and a GPC column (manufactured by Tosoh Corporation, TSKgel SuperMultiporeHZ-N or TSKgel SuperMultiporeHZ-H) at a column temperature of 40°C, using tetrahydrofuran as an eluent (elution solvent), and using polystyrene (manufactured by Showa Denko K. K., Shodex) as a standard sample at a flow rate of 0.35 mL/min.

A viscosity of each of the polyorganosiloxane (a1) and the polyorganosiloxane (a2) is not particularly limited, but is usually 10 to 1,000,000 (mPa·s), and is preferably 50 to 20,000 (mPa·s) from the viewpoint of realizing the effect of the present invention with excellent reproducibility. Note that the viscosity of each of the polyorganosiloxane (a1) and the polyorganosiloxane (a2) is a value measured at 25°C with an E-type rotational viscometer.

The polyorganosiloxane (a1) and the polyorganosiloxane (a2) react with each other by a hydrosilylation reaction to form a film. Accordingly, a curing mechanism is different from that via, for example, a silanol group, and therefore, any siloxane does not need to have a silanol group or a functional group that forms a silanol group by hydrolysis, such as an alkyloxy group.

The adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum-based catalysts such as platinum black, platinum(II) chloride, chloroplatinic acid, a reaction product of chloroplatinic acid and monohydric alcohol, a complex of chloroplatinic acid and olefins, and platinum bisacetoacetate.

Examples of a complex of platinum and olefins include, but are not limited to, a complex of divinyltetramethyldisiloxane and platinum.

The amount of the platinum group metal-based catalyst (A2) is not particularly limited, but is usually in a range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as it can suppress the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, but is usually 1000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

The protective adhesive composition used in the present invention may contain a solvent for the purpose of adjusting the viscosity and the like, and specific examples thereof include, but are not limited to, an aliphatic hydrocarbon, an aromatic hydrocarbon, and a ketone.

More specific examples of the solvent include, but are not limited to, hexane, heptane, octane, nonane, decane, undecane, dodecane, isododecane, menthane, limonene, toluene, xylene, mesitylene, cumene, methyl isobutyl ketone (MIBK), butyl acetate, diisobutyl ketone, 2-octanone, 2-nonanone, and 5-nonanone. Such solvents can be used alone or in combination of two or more kinds thereof.

In a case where the protective adhesive composition used in the present invention contains a solvent, a content thereof is appropriately determined in consideration of a viscosity of a desired composition, a coating method to be employed, a thickness of a film to be produced, and the like, but is in a range of about 10 to 90 mass% with respect to the entire protective adhesive composition.

A viscosity of the protective adhesive composition used in the present invention is not particularly limited, but is usually 500 to 20,000 mPa·s and preferably 1,000 to 6,000 mPa·s at 25°C. The viscosity of the protective adhesive composition used in the present invention can be adjusted by changing a type and a ratio of a solvent to be used, a concentration of film forming components, and the like in consideration of various factors such as a coating method to be used and a desired film thickness.

In the present invention, the film forming component means a component other than the solvent contained in the composition.

As an example, the protective adhesive composition used in the present invention can be prepared by mixing the component (A) with a solvent when used.

Note that, when the protective adhesive composition is prepared, the protective adhesive composition may be appropriately heated within a range in which the components are not decomposed or altered.

In the present invention, for the purpose of removing foreign substances, a solvent, a solution, or the like to be used may be filtered using a filter or the like during the preparation of the protective adhesive composition or after mixing all the components.

A thickness of the protective adhesive layer included in the laminate of the present invention is not particularly limited, but is preferably 10 to 100 µm, and more preferably 20 to 50 µm, from the viewpoint of obtaining an excellent bump deformation suppression effect with excellent reproducibility.

### <Peeling Adhesive Layer>

The peeling adhesive layer is interposed between the support substrate and the protective adhesive layer.

The peeling adhesive layer is preferably in contact with the support substrate and the protective adhesive layer from the viewpoint of obtaining an excellent bump deformation suppression effect with excellent reproducibility.

The peeling adhesive layer is formed of a peeling adhesive composition, and the peeling adhesive composition contains a component (A) which is cured by a hydrosilylation reaction and a peeling agent component (B) which does not cause a curing reaction together with the component (A).

### <<Peeling Adhesive Composition>>

The peeling adhesive composition contains a component (A) which is cured by a hydrosilylation reaction.

The peeling adhesive composition used in the present invention contains a polyorganosiloxane.

In a preferred aspect, the peeling adhesive composition used in the present invention contains a component (A) which is cured to be an adhesive component and a peeling agent component (B) which does not cause a curing reaction together with the component (A). The peeling agent component (B) which does not cause a curing reaction is a polyorganosiloxane. Note that, in the present invention, "which does not cause a curing reaction" does not mean that all curing reactions are not caused, but means that a curing reaction occurring in the component (A) which is cured is not caused.

Specifically, the component (A) is a polyorganosiloxane component (A') which is cured by a hydrosilylation reaction.

The component (A) or the polyorganosiloxane component (A') are as described in the section of <<Protective Adhesive Composition>> of <<Protective Adhesive Layer>> described above.

The component (A) or the polyorganosiloxane component (A') contained in the protective adhesive composition and the component (A) or the polyorganosiloxane component (A') contained in the peeling adhesive composition may be the same type of component or different types of components.

The peeling adhesive composition contains the peeling agent component (B) which does not cause a curing reaction together with the component (A), but the entire composition causes a crosslinking reaction by hydrosilylation and is cured.

It is preferable that the component (A) which is cured in the peeling adhesive composition does not contain a component containing an aromatic ring.

The peeling adhesive composition used in the present invention contains a peeling agent component (B) which does not cause a curing reaction together with the component (A) which is cured. The peeling adhesive composition contains such a peeling agent component (B), such that a layer adjacent to the peeling adhesive layer or the substrate can be easily peeled off.

The peeling agent component (B) is a polyorganosiloxane selected from an epoxy group-containing polyorganosiloxane, a methyl group-containing polyorganosiloxane, and a phenyl group-containing polyorganosiloxane.

In addition, in another preferred aspect, examples of the peeling agent component (B) include a polydimethylsiloxane, and the polydimethylsiloxane may be modified. Examples of the polydimethylsiloxane which may be modified include, but are not limited to, an epoxy group-containing polydimethylsiloxane, an unmodified polydimethylsiloxane, and a phenyl group-containing polydimethylsiloxane.

Preferred examples of the polyorganosiloxane as the peeling agent component (B) include, but are not limited to, an epoxy group-containing polyorganosiloxane, a methyl group-containing polyorganosiloxane, and a phenyl group-containing polyorganosiloxane.

A weight average molecular weight of the polyorganosiloxane as the peeling agent component (B) is not particularly limited, but is usually 100,000 to 2,000,000, and is preferably 200,000 to 1,200,000 and more preferably 300,000 to 900,000 from the viewpoint of realizing the effect of the present invention with excellent reproducibility. In addition, a dispersity thereof is not particularly limited, but is usually 1.0 to 10.0, and is preferably 1.5 to 5.0 and more preferably 2.0 to 3.0 from the viewpoint of realizing preferred peeling with excellent reproducibility. Note that the weight average molecular weight and the dispersity can be measured by the above methods related to the polysiloxane.

A complex viscosity of the polyorganosiloxane as the peeling agent component (B) can be measured at 25°C using a rheometer (for example, Rheometer MCR-302 manufactured by Anton Paar GmbH).

Examples of the epoxy group-containing polyorganosiloxane include an epoxy group-containing polyorganosiloxane containing a siloxane unit (D¹⁰ unit) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group include the examples described above.

The epoxy group in the organic group containing an epoxy group may be an independent epoxy group without being fused with other rings, or may be an epoxy group forming a fused ring with other rings, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane include, but are not limited to, an epoxy group-containing polydimethylsiloxane.

The epoxy group-containing polyorganosiloxane contains the siloxane unit (D¹⁰ unit) described above, but may contain a Q unit, an M unit, and/or a T unit in addition to the D¹⁰ unit.

In a preferred aspect of the present invention, specific examples of the epoxy group-containing polyorganosiloxane include a polyorganosiloxane containing only a D¹⁰ unit, a polyorganosiloxane containing a D¹⁰ unit and a Q unit, a polyorganosiloxane containing a D¹⁰ unit and an M unit, a polyorganosiloxane containing a D¹⁰ unit and a T unit, a polyorganosiloxane containing a D¹⁰ unit, a Q unit, and an M unit, a polyorganosiloxane containing a D¹⁰ unit, an M unit, and a T unit, and a polyorganosiloxane containing a D¹⁰ unit, a Q unit, an M unit, and a T unit.

The epoxy group-containing polyorganosiloxane is preferably an epoxy group-containing polydimethylsiloxane having an epoxy value of 0.1 to 5. In addition, a weight average molecular weight thereof is not particularly limited, but is usually 1,500 to 500,000, and is preferably 100,000 or less from the viewpoint of suppressing precipitation in the adhesive.

Specific examples of the epoxy group-containing polyorganosiloxane include, but are not limited to, an epoxy group-containing polyorganosiloxane represented by each of Formulas (E1) to (E3).

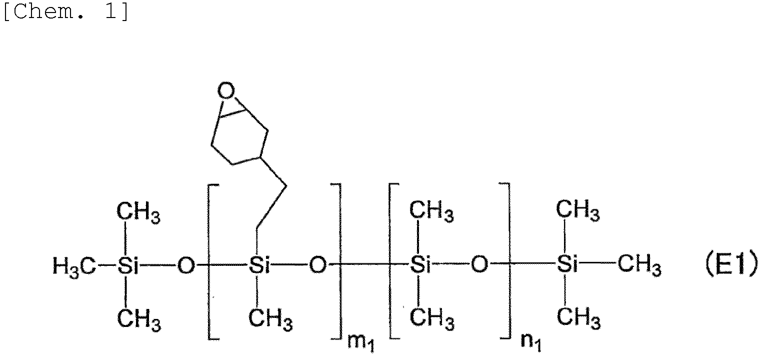

(m₁ and n₁ represent the numbers of repeating units and are positive integers.)

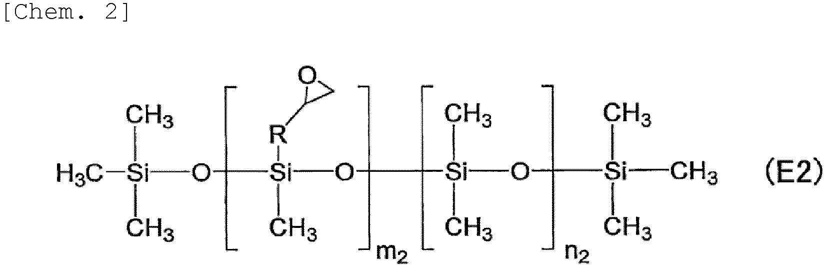

(m₂ and n₂ represent the numbers of repeating units and are positive integers, and R is an alkylene group having 1 to 10 carbon atoms.)

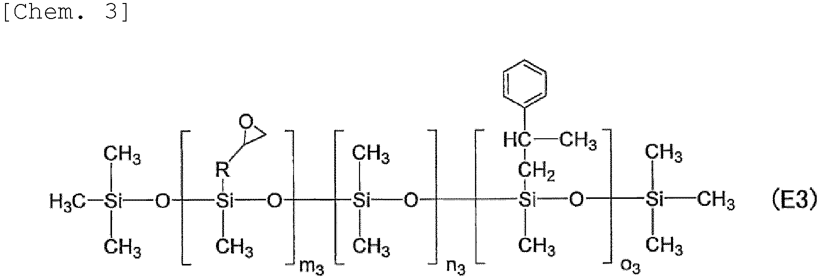

(m₃, n₃, and o₃ represent the numbers of repeating units and are positive integers, and R is an alkylene group having 1 to 10 carbon atoms.)

Examples of the methyl group-containing polyorganosiloxane include a methyl group-containing polyorganosiloxane containing a siloxane unit (D²⁰⁰ unit) represented by R²¹⁰R²²⁰SiO_{2/2}, and preferably a methyl group-containing polyorganosiloxane containing a siloxane unit (D²⁰ unit) represented by R²¹R²¹SiO_{2/2}.

R²¹⁰ and R²²⁰ are groups bonded to silicon atoms, each independently represent an alkyl group, at least one of them is a methyl group, and specific examples of the alkyl group are the examples described above.

R²¹ is a group bonded to a silicon atom and represents an alkyl group, and specific examples of the alkyl group include the examples described above. Among them, R²¹ is preferably a methyl group.

In the present invention, preferred examples of the methyl group-containing polyorganosiloxane include, but are not limited to, a polydimethylsiloxane.

The methyl group-containing polyorganosiloxane contains the siloxane unit (D²⁰⁰ unit or D²⁰ unit) described above, but may contain a Q unit, an M unit, and/or a T unit in addition to the D²⁰⁰ unit and the D²⁰ unit.

In an aspect of the present invention, specific examples of the methyl group-containing polyorganosiloxane include a polyorganosiloxane containing only a D²⁰⁰ unit, a polyorganosiloxane containing a D²⁰⁰ unit and a Q unit, a polyorganosiloxane containing a D²⁰⁰ unit and an M unit, a polyorganosiloxane containing a D²⁰⁰ unit and a T unit, a polyorganosiloxane containing a D²⁰⁰ unit, a Q unit, and an M unit, a polyorganosiloxane containing a D²⁰⁰ unit, an M unit, and a T unit, and a polyorganosiloxane containing a D²⁰⁰ unit, a Q unit, an M unit, and a T unit.

In a preferred aspect of the present invention, specific examples of the methyl group-containing polyorganosiloxane include a polyorganosiloxane containing only a D²⁰ unit, a polyorganosiloxane containing a D²⁰ unit and a Q unit, a polyorganosiloxane containing a D²⁰ unit and an M unit, a polyorganosiloxane containing a D²⁰ unit and a T unit, a polyorganosiloxane containing a D²⁰ unit, a Q unit, and an M unit, a polyorganosiloxane containing a D²⁰ unit, an M unit, and a T unit, and a polyorganosiloxane containing a D²⁰ unit, a Q unit, an M unit, and a T unit.

Specific examples of the methyl group-containing polyorganosiloxane include, but are not limited to, a methyl group-containing polyorganosiloxane represented by of Formula (M1).

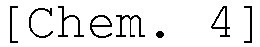

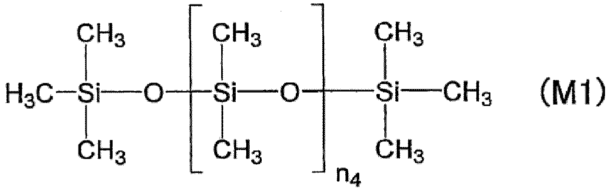

(n₄ represents the number of repeating units and is a positive integer.)

Examples of the phenyl group-containing polyorganosiloxane include a phenyl group-containing polyorganosiloxane containing a siloxane unit (D³⁰ unit) represented by R³¹R³²SiO_{2/2}.

R³¹ is a group bonded to a silicon atom and represents a phenyl group or an alkyl group, and R³² is a group bonded to a silicon atom and represents a phenyl group. Specific examples of the alkyl group include the examples described above, and a methyl group is preferable.

The phenyl group-containing polyorganosiloxane contains the siloxane unit (D³⁰ unit) described above, but may contain a Q unit, an M unit, and/or a T unit in addition to the D³⁰ unit.

In a preferred aspect of the present invention, specific examples of the phenyl group-containing polyorganosiloxane include a polyorganosiloxane containing only a D³⁰ unit, a polyorganosiloxane containing a D³⁰ unit and a Q unit, a polyorganosiloxane containing a D³⁰ unit and an M unit, a polyorganosiloxane containing a D³⁰ unit and a T unit, a polyorganosiloxane containing a D³⁰ unit, a Q unit, and an M unit, a polyorganosiloxane containing a D³⁰ unit, an M unit, and a T unit, and a polyorganosiloxane containing a D³⁰ unit, a Q unit, an M unit, and a T unit.

Specific examples of the methyl group-containing polyorganosiloxane include, but are not limited to, a methyl group-containing polyorganosiloxane represented by of Formula (P1) or (P2).

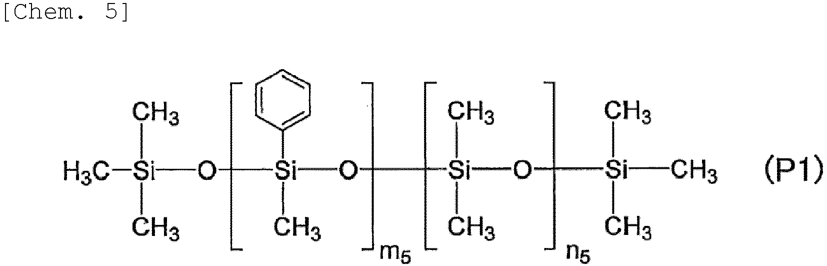

(m₅ and n₅ represent the numbers of repeating units and are positive integers.)

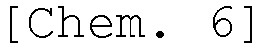

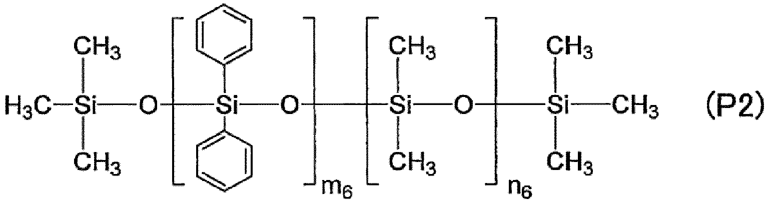

(m₆ and n₆ represent the numbers of repeating units and are positive integers.)

The polyorganosiloxane as the peeling agent component (B) may be a commercially available product or a synthetic product.

Examples of the commercially available product of the polyorganosiloxane include, but are not limited to, WACKERSILICONE FLUID AK series (AK50, AK 350, AK 1000, AK 10000, and AK 1000000) and GENIOPLAST GUM, which are products manufactured by Wacker Chemie AG, dimethyl silicone oils (KF-96L, KF-96A, KF-96, KF-96H, KF-69, KF-965, and KF-968) and a cyclic dimethyl silicone oil (KF-995) manufactured by Shin-Etsu Chemical Co., Ltd.; epoxy group-containing polyorganosiloxanes (trade names: CMS-227 and ECMS-327) manufactured by Gelest Inc., epoxy group-containing polyorganosiloxanes (KF-101, KF-1001, KF-1005, and X-22-343) manufactured by Shin-Etsu Chemical Co., Ltd., and an epoxy group-containing polyorganosiloxane (BY16-839) manufactured by Dow Corning Corporation; and phenyl group-containing polyorganosiloxanes (PMM-1043, PMM-1025, PDM-0421, and PDM-0821) manufactured by Gelest Inc., a phenyl group-containing polyorganosiloxane (KF50-3000CS) manufactured by Shin-Etsu Chemical Co., Ltd., and phenyl group-containing polyorganosiloxanes (TSF431 and TSF433) manufactured by MOMENTIVE.

The peeling adhesive composition used in the present invention contains the peeling agent component (B) which does not cause a curing reaction together with the component (A) which is cured, and in a more preferred aspect, a polyorganosiloxane is contained as the peeling agent component (B).

As an example, the peeling adhesive composition used in the present invention can contain the component (A) and the peeling agent component (B) at any ratio, but in consideration of a balance between adhesiveness and peelability, a ratio of the component (A) to the peeling agent component (B) is preferably 99.995:0.005 to 30:70 and more preferably 99.9:0.1 to 75:25 in terms of mass ratio [(A):(B)].

That is, in a case where the polyorganosiloxane component (A') which is cured by a hydrosilylation reaction is contained, a ratio of the component (A') to the peeling agent component (B) is preferably 99.995:0.005 to 30:70 and more preferably 99.9:0.1 to 75:25 in terms of mass ratio [(A'):(B)].

The peeling adhesive composition used in the present invention may contain a solvent for the purpose of adjusting the viscosity and the like, and specific examples thereof include, but are not limited to, an aliphatic hydrocarbon, an aromatic hydrocarbon, and a ketone.

More specific examples of the solvent include, but are not limited to, hexane, heptane, octane, nonane, decane, undecane, dodecane, isododecane, menthane, limonene, toluene, xylene, mesitylene, cumene, methyl isobutyl ketone (MIBK), butyl acetate, diisobutyl ketone, 2-octanone, 2-nonanone, and 5-nonanone. Such solvents can be used alone or in combination of two or more kinds thereof.

In a case where the peeling adhesive composition used in the present invention contains a solvent, a content thereof is appropriately determined in consideration of a viscosity of a desired composition, a coating method to be employed, a thickness of a film to be produced, and the like, but is in a range of about 10 to 90 mass% with respect to the entire peeling adhesive composition.

A viscosity of the peeling adhesive composition used in the present invention is not particularly limited, but is usually 500 to 20,000 mPa·s and preferably 1,000 to 5,000 mPa·s at 25°C. The viscosity of the peeling adhesive composition used in the present invention can be adjusted by changing a type and a ratio of a solvent to be used, a concentration of film forming components, and the like in consideration of various factors such as a coating method to be used and a desired film thickness.

As an example, the peeling adhesive composition used in the present invention can be prepared by mixing the component (A) with the peeling agent component (B) and a solvent when used.

The mixing order is not particularly limited, and examples of a method by which a peeling adhesive composition can be easily and reproducibly prepared include, but are not limited to, a method in which the component (A) and the peeling agent component (B) are dissolved in a solvent, and a method in which a part of the component (A) and the peeling agent component (B) are dissolved in a solvent, the rest is dissolved in the solvent, and the obtained solution is mixed. Note that, when the peeling adhesive composition is prepared, the peeling adhesive composition may be appropriately heated within a range in which the components are not decomposed or altered.

In the present invention, for the purpose of removing foreign substances, a solvent, a solution, or the like to be used may be filtered using a filter or the like during the preparation of the peeling adhesive composition or after mixing all the components.

A thickness of the peeling adhesive layer included in the laminate of the present invention is not particularly limited, but is preferably 10 to 100 µm, and more preferably 20 to 50 µm, from the viewpoint of obtaining an excellent peeling effect with excellent reproducibility.

Hereinafter, an example of the laminate will be described with reference to the drawings.

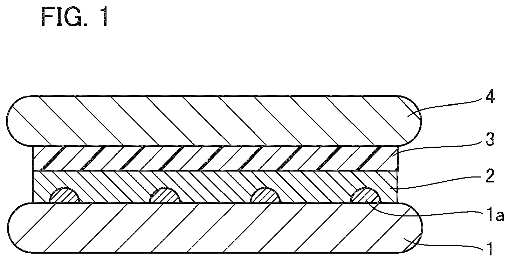

Fig. 1 is a schematic cross-sectional view of an example of a laminate.

The laminate of Fig. 1 includes a semiconductor substrate 1 having bumps 1a, a protective adhesive layer 2, a peeling adhesive layer 3, and a support substrate 4 in this order.

The bumps 1a of the semiconductor substrate 1 are arranged on a side of the support substrate 4.

The protective adhesive layer 2 is interposed between the semiconductor substrate 1 and the support substrate **4.** The protective adhesive layer 2 is in contact with the semiconductor substrate 1. Then, the protective adhesive layer 2 covers the bumps 1a.

The peeling adhesive layer 3 is interposed between the protective adhesive layer 2 and the support substrate **4.** The peeling adhesive layer 3 is in contact with the protective adhesive layer 2 and the support substrate **4.**

The laminate of the present invention is preferably manufactured, for example, by the following method for manufacturing a laminate of the present invention.

### (Method For Manufacturing Laminate)

The method for manufacturing a laminate of the present invention includes a protective adhesive coating layer formation step, a protective adhesive layer formation step, a peeling adhesive coating layer formation step, and a peeling adhesive layer formation step, and further includes other steps such as a bonding step as necessary.

### <Protective Adhesive Coating Layer Formation Step>

The protective adhesive coating layer formation step is a step of forming a protective adhesive coating layer by applying the protective adhesive composition onto a surface of the semiconductor substrate on which the bump exists. The protective adhesive composition is applied to the semiconductor substrate with a bump, such that it is possible to form a protective adhesive coating layer so as to follow irregularities caused by the bumps without generating a gap between the protective adhesive coating layer and the substrate, and as a result, it is possible to preferably form a protective adhesive layer capable of realizing excellent bump protection without causing a situation in which an upper portion of the bump protrudes from the protective adhesive layer even when the thickness of the protective adhesive layer to be formed is thinner than the bump height. Note that this point does not prevent the protective adhesive layer from being thicker than the bump height of the semiconductor substrate in the laminate according to the present invention, and even in such a case, a protective adhesive layer capable of realizing excellent bump protection can be preferably formed.

In this way, a protective adhesive coating layer is formed on the semiconductor substrate with a bump.

The coating method is not particularly limited, but is usually a spin coating method. Note that a method of separately forming a coating film by a spin coating method or the like and attaching the sheet-like coating film as a protective adhesive coating layer can be obtained.

A thickness of the protective adhesive coating layer is appropriately determined in consideration of the desired thickness of the protective adhesive layer in the laminate, the bump height, and the like.

For the reason that the protective adhesive composition contains a solvent or the like, the applied protective adhesive composition may be heated for the purpose of drying the coating film of the applied protective adhesive composition.

A heating temperature of the applied protective adhesive composition varies depending on the type and amount of the adhesive component contained in the protective adhesive composition, whether or not a solvent is contained, a boiling point of a solvent to be used, a desired thickness of the protective adhesive layer, and the like, and thus cannot be generally specified, but the heating temperature is usually 80 to 150°C, and a heating time is usually 30 seconds to 5 minutes.

The heating can be performed using a hot plate, an oven, or the like.

### <Protective Adhesive Layer Formation Step>

In the protective adhesive layer formation step, the protective adhesive coating layer is heated to form a protective adhesive layer.

The temperature and time of heating are not particularly limited as long as they are temperature and time at which the protective adhesive coating layer is converted into the protective adhesive layer.

The heating temperature is preferably 120°C or higher and more preferably 150°C or higher from the viewpoint of realizing a sufficient curing rate and the like, and is preferably 250°C or lower from the viewpoint of preventing alteration of the respective layers (including the support substrate and the semiconductor substrate) constituting the laminate. The heating temperature is more preferably 180 to 200°C.

The heating time is preferably 1 minute or longer, and more preferably 5 minutes or longer, from the viewpoint of realizing preferred bonding of the respective layers (including the support substrate and the semiconductor substrate) constituting the laminate, and is preferably 180 minutes or shorter, and more preferably 120 minutes or shorter, from the viewpoint of suppressing or avoiding adverse effects on the respective layers and the like due to excessive heating. The heating time is more preferably 1 to 20 minutes from the viewpoint of substrate treatment efficiency.

The heating can be performed using a hot plate, an oven, or the like.

### <Peeling Adhesive Coating Layer Formation Step>

The peeling adhesive coating layer formation step is a step of forming a peeling adhesive coating layer by applying the peeling adhesive composition onto the support substrate or applying the peeling adhesive composition onto the protective adhesive layer.

The peeling adhesive coating layer formation step is not particularly limited as long as it is a step of forming a peeling adhesive coating layer, and examples thereof include a step including a method of applying the peeling adhesive composition onto the protective adhesive layer or the support substrate and then heating (pre-heating treatment) the peeling adhesive composition to form a peeling adhesive coating layer that is an uncured or non-completely cured peeling adhesive layer. In this way, the peeling adhesive coating layer is formed on the protective adhesive layer formed on the semiconductor substrate or on the support substrate.

The coating method is not particularly limited, but is usually a spin coating method. Note that a method of separately forming a coating film by a spin coating method or the like and attaching the sheet-like coating film as a peeling adhesive coating layer can be adopted.

A thickness of the peeling adhesive coating layer is appropriately determined in consideration of a desired thickness of the peeling adhesive layer in the laminate and the like.

For the reason that the peeling adhesive composition contains a solvent or the like, the applied peeling adhesive composition may be heated for the purpose of drying the coating film of the applied peeling adhesive composition.

A heating temperature of the applied peeling adhesive composition varies depending on the type and amount of the adhesive component contained in the peeling adhesive composition, whether or not a solvent is contained, a boiling point of a solvent to be used, a desired thickness of the peeling adhesive layer, and the like, and thus cannot be generally specified, but the heating temperature is usually 80 to 150°C, and a heating time is usually 30 seconds to 5 minutes.

The heating can be performed using a hot plate, an oven, or the like.

### <Peeling Adhesive Layer Formation Step>

In the peeling adhesive layer formation step, the peeling adhesive coating layer is heated to form a peeling adhesive layer.

The peeling adhesive layer formation step is not particularly limited as long as it is a step in which the peeling adhesive coating layer is heated to form a peeling adhesive layer (post-heating treatment). For example, two substrates (the semiconductor substrate and the support substrate) are arranged so as to interpose two layers (the protective adhesive layer and the peeling adhesive coating layer) therebetween using the semiconductor substrate on which the protective adhesive layer and the peeling adhesive coating layer are formed and the support substrate, or using the semiconductor substrate on which the protective adhesive layer is formed and the support substrate on which the peeling adhesive coating layer is formed so that the support substrate and the peeling adhesive coating layer are in contact with each other and the peeling adhesive coating layer and the protective adhesive layer are in contact with each other, and then the heating treatment may be performed.

The temperature and time of heating are not particularly limited as long as they are temperature and time at which the peeling adhesive coating layer is converted into the peeling adhesive layer.

The heating temperature is preferably 120°C or higher and more preferably 150°C or higher from the viewpoint of realizing a sufficient curing rate and the like, and is preferably 250°C or lower from the viewpoint of preventing alteration of the respective layers (including the support substrate and the semiconductor substrate) constituting the laminate. The heating temperature is more preferably 180 to 200°C.

The heating time is preferably 1 minute or longer, and more preferably 5 minutes or longer, from the viewpoint of realizing preferred bonding of the respective layers (including the support substrate and the semiconductor substrate) constituting the laminate, and is preferably 180 minutes or shorter, and more preferably 120 minutes or shorter, from the viewpoint of suppressing or avoiding adverse effects on the respective layers and the like due to excessive heating. The heating time is more preferably 1 to 20 minutes from the viewpoint of substrate treatment efficiency.

The heating can be performed using a hot plate, an oven, or the like.

### <Bonding Step>

It is preferable to perform the bonding step between the peeling adhesive coating layer formation step and the peeling adhesive layer formation step in order to sufficiently bond the semiconductor substrate and the support substrate to each other.

The bonding step is not particularly limited as long as the substrate and the layer can be bonded to each other and the substrate or the layer is not damaged, but typically, the bonding step is a step in which a load can be applied in a thickness direction of the support substrate and the semiconductor substrate, and more preferably a step in which a load can be applied in a thickness direction of the support substrate and the semiconductor substrate under reduced pressure.

The load is not particularly limited as long as the substrate and the layer can be bonded to each other and the substrate or the layer is not damaged, but is, for example, 10 to 1,000 N.

A degree of reduced pressure is not particularly limited as long as the substrate and the layer can be bonded to each other and the substrate or the layer is not damaged, but is, for example, 10 to 10,000 Pa.

### (Method for Manufacturing Semiconductor Substrate)

The laminate of the present invention is used for temporary adhesion for processing a semiconductor substrate, and is used for an application in which a support substrate and a semiconductor substrate are separated after processing of the semiconductor substrate in the laminate.

The method for manufacturing a semiconductor substrate of the present invention includes at least a processing step of processing a semiconductor substrate and a peeling step of separating a support substrate and the processed semiconductor substrate, and further includes other steps such as a removal step as necessary.

### <Processing Step>

The processing step is not particularly limited as long as it is a step of processing the semiconductor substrate in the laminate of the present invention, and includes, for example, a polishing treatment, a through-electrode forming treatment, or the like.

For example, in various processing steps, processing may be performed at a high temperature and a high pressure, but the laminate of the present invention can effectively prevent bump deformation of the semiconductor substrate even when processing is performed at a high temperature (for example, 250 to 350°C) or a high pressure.

### <<Polishing Treatment>>

The polishing treatment is not particularly limited as long as it is a treatment of polishing the surface of the semiconductor substrate opposite to the surface on which the bumps exist to thin the semiconductor substrate, and examples thereof include physical polishing using a polishing agent or a grindstone.

The polishing treatment can be performed using a general polishing device used for polishing a semiconductor substrate.

By the polishing treatment, the thickness of the semiconductor substrate is reduced, and a semiconductor substrate thinned to a desired thickness is obtained. A thickness of the thinned semiconductor substrate is not particularly limited, but may be, for example, 10 to 300 µm or 30 to 100 µm.

### <<Through-Electrode Formation Step>>

A through-electrode for realizing conduction between the thinned semiconductor substrates when a plurality of thinned semiconductor substrates are laminated may be formed on the polished semiconductor substrate.

Therefore, the method for manufacturing a semiconductor substrate may include a through-electrode forming treatment for forming a through-electrode on the polished semiconductor substrate after the polishing treatment and before the peeling step.

A method for forming a through-electrode on the semiconductor substrate is not particularly limited, and examples thereof include forming a through-hole and filling the formed through-hole with a conductive material.

The through-hole is formed by, for example, photolithography.

The filling of the through-hole with the conductive material is performed by, for example, a plating technique.

### <Peeling Step>

The peeling step is not particularly limited as long as it is a step of separating the support substrate and the processed semiconductor substrate after the processing step by separating the protective adhesive layer and the peeling adhesive layer.

For example, there is a method in which mechanical peeling is performed with equipment having a sharp portion (so-called a debonder). Specifically, for example, after the sharp portion is inserted between the semiconductor substrate and the support substrate, the semiconductor substrate and the support substrate are separated. Usually, peeling occurs at any of the inside of the peeling adhesive layer, the interface between the peeling adhesive layer and the protective adhesive layer, and the interface between the peeling adhesive layer and the support substrate, and peeling often occurs when two or more of them are combined. Note that the peeling occurring in the peeling adhesive layer means that the peeling adhesive layer is torn.

### <Removal Step>

The removal step is not particularly limited as long as it is a step in which the protective adhesive layer formed on the semiconductor substrate and the residue of the peeling adhesive layer formed thereon are removed after the peeling step, and examples thereof include a method in which the residue of the peeling adhesive layer is dissolved and removed using a cleaning agent composition. In addition, removal using a removal tape or the like may be combined with dissolution removal.

In a case where a cleaning agent composition is used, for example, the semiconductor substrate with a protective adhesive layer can be immersed in the cleaning agent composition or can be sprayed with the cleaning agent composition.

When the semiconductor substrate is cleaned using the cleaning agent composition, care is taken so that the bump is not damaged.

Preferred examples of the cleaning agent composition used in the present invention include cleaning agent compositions containing a quaternary ammonium salt and a solvent.

The quaternary ammonium salt is composed of a quaternary ammonium cation and an anion, and is not particularly limited as long as it is used for this type of application.

Examples of such a quaternary ammonium cation typically include tetra(hydrocarbon)ammonium cations. On the other hand, examples of an anion paired therewith include, but are not limited to, a hydroxide ion (OH⁻); halogen ions such as a fluorine ion (F⁻), a chlorine ion (Cl⁻), a bromine ion (Br⁻), and an iodine ion (I⁻); a tetrafluoroborate ion (BF₄⁻); and a hexafluorophosphate ion (PF₆⁻).

In the present invention, the quaternary ammonium salt is preferably a halogen-containing quaternary ammonium salt, and more preferably a fluorine-containing quaternary ammonium salt.

In the quaternary ammonium salt, the halogen atom may be contained in the cation or the anion, but is preferably contained in the anion.

In a preferred aspect, the fluorine-containing quaternary ammonium salt is tetra(hydrocarbon)ammonium fluoride.

Specific examples of the hydrocarbon group in the tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred aspect, the tetra(hydrocarbon)ammonium fluoride includes tetraalkylammonium fluoride.

Specific examples of the tetraalkylammonium fluoride include, but are not limited to, tetramethylammonium fluoride, tetraethylammonium fluoride, tetrapropylammonium fluoride, and tetrabutylammonium fluoride (also referred to as tetrabutylammonium fluoride). Among them, tetrabutylammonium fluoride is preferable.

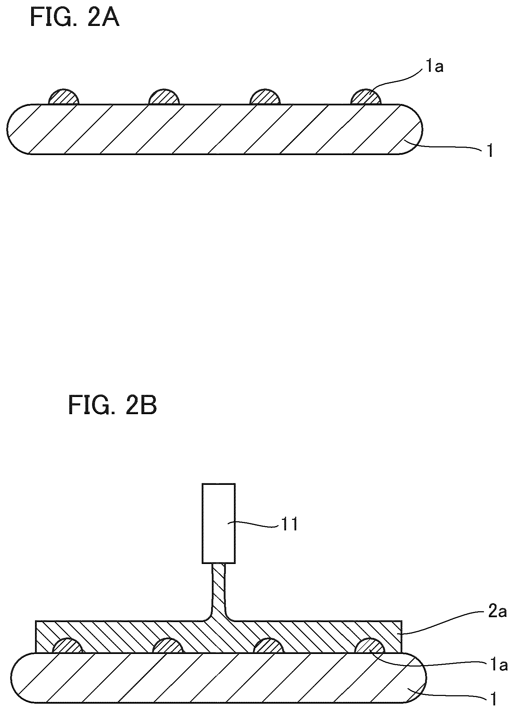

An example of an aspect in which manufacturing of a laminate and manufacturing of a thinned wafer are performed in series will be described with reference to Figs. 2A to 2H.

Figs. 2A to 2H are views for explaining the aspect in which the laminate is manufactured and the thinned wafer is manufactured.

First, a wafer 1 having bumps 1a is prepared (Fig. 2A).

Next, a protective adhesive composition is applied onto a surface of the wafer 1 on which the bumps 1a exist by spin coating using a coating device 11 to form a protective adhesive coating layer 2a (Fig. 2B).

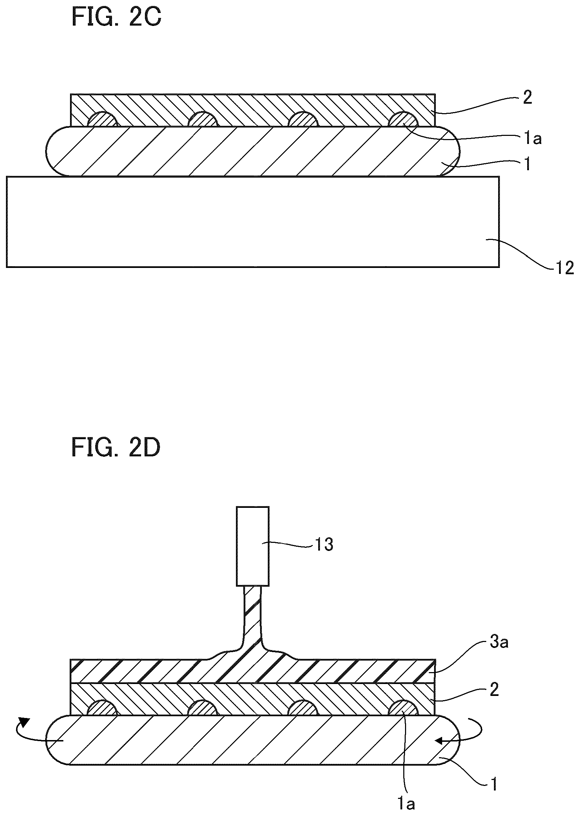

Next, a heating device (hot plate) 12 is placed on a surface of the wafer 1 opposite to the surface on which the bumps 1a exist, and the protective adhesive coating layer 2a is heated by the heating device 12 to be cured and converted into a protective adhesive layer 2 (Fig. 2C).

Next, a peeling adhesive composition is applied onto the protective adhesive layer 2 by spin coating using a coating device 13 to form a peeling adhesive coating layer 3a (Fig. 2D).

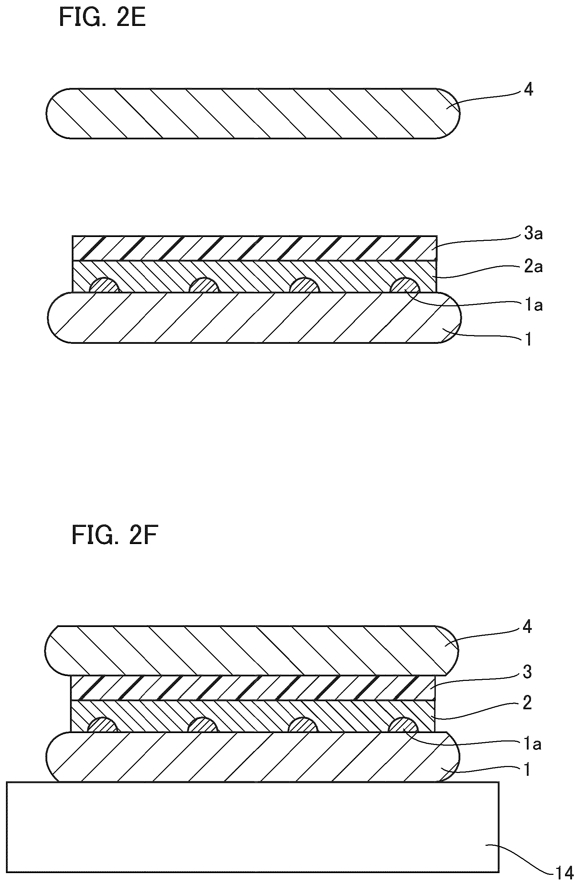

Next, a support substrate 4 is arranged on the peeling adhesive coating layer 3a (Fig. 2E).

Next, after a load is applied in a thickness direction of the wafer 1 and the support substrate 4 under reduced pressure, a heating device (hot plate) 14 is placed on the surface of the wafer 1 opposite to the surface on which the bumps 1a exist, and the peeling adhesive coating layer 3a is heated by a heating device 14 to be converted into a peeling adhesive layer 3 (Fig. 2F).

A laminate is obtained by the steps illustrated in Figs. 2A to 2F.

Next, an example of manufacturing a thinned wafer will be described.

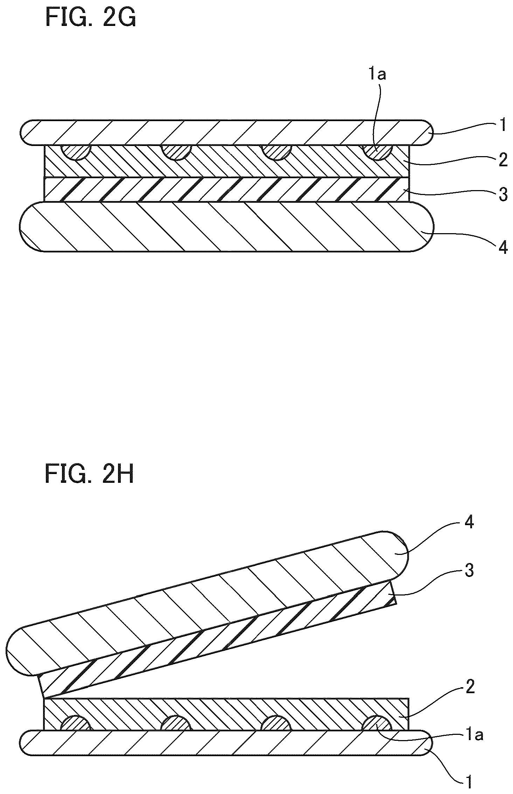

Next, the surface of the wafer 1 opposite to the surface on which the bumps 1a exist is polished using a polishing device (not illustrated) to thin the wafer 1 (Fig. 2G). Note that a through-electrode or the like may be formed on the thinned wafer 1.

Next, the thinned wafer 1 and the support substrate 4 are peeled off using a peeling device (not illustrated) (Fig. 2H).

Next, the protective adhesive layer 2 or the like is dissolved and removed from the wafer 1 thinned by a cleaning agent composition using a cleaning device (not illustrated) to clean the thinned wafer 1.

As described above, the thinned wafer 1 is obtained.

### Examples

Hereinafter, the present invention will be described in more detail with reference to Examples, but the present invention is not limited to the following Examples. Note that the devices used are as follows.

(1) Stirrer A: Rotation and revolution mixer ARE-500 manufactured by Thinky Corporation
(2) Measurement of complex viscosity: Rheometer MCR-302 manufactured by Anton Paar GmbH
(3) Vacuum bonding device X: Manual bonder manufactured by SUSS MicroTec SE
(4) Vacuum bonding device Y: Auto bonder manufactured by SUSS MicroTec SE
(5) Peeling device X: Manual debonder manufactured by SUSS MicroTec SE

Structural formulas of the components used in Examples are shown below. 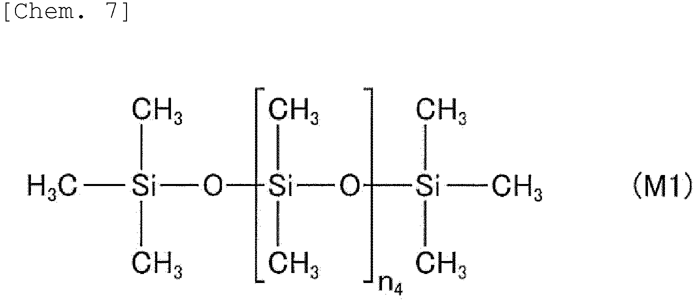 (n₄ represents the number of repeating units and is a positive integer.) 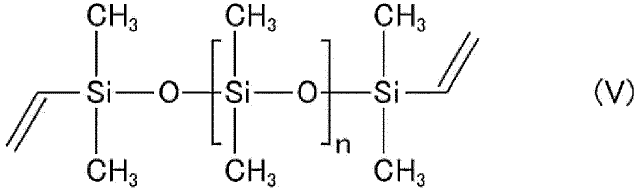 (n represents the number of repeating units and is a positive integer.) 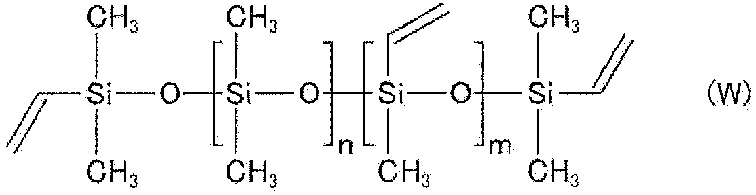 (n and m each represent the number of repeating units and are positive integers.)

### [Measurement of Molecular Weight]

A weight average molecular weight, a number average molecular weight, and a dispersity of polydimethylsiloxane were measured, for example, using a GPC apparatus (EcoSEC or HLC-8320GPC manufactured by Tosoh Corporation) and a GPC column (TSKgel SuperMultiporeHZ-N or TSKgel SuperMultiporeHZ-H manufactured by Tosoh Corporation) at a column temperature of 40°C, using tetrahydrofuran as an eluent (elution solvent), and using polystyrene (manufactured by Showa Denko K. K., Shodex) as a standard sample at a flow rate of 0.35 mL/min.

### [1-1] Preparation of Protective Adhesive Composition

### [Preparation Example 1]

Into a 600 mL stirring vessel with a stirrer A, 62.10 g of a vinyl group-containing linear polydimethylsiloxane having a viscosity of 200 mPa·s represented by Formula (V) and 82.25 g of a base polymer containing a vinyl group-containing MQ resin (manufactured by Wacker Chemie AG) as the component (a1), 15.23 g of a SiH group-containing linear polydimethylsiloxane (manufactured by Wacker Chemie AG) having a viscosity of 100 mPa·s as the component (a2), and 0.42 g of 1-ethynyl-1-cyclohexanol (manufactured by Wacker Chemie AG) as the component (A3) were added, and stirring was performed with the stirrer A for 5 minutes, thereby obtaining a mixture (I).

In a 50 mL screw tube, 0.24 g of a platinum catalyst (manufactured by Wacker Chemie AG) as the component (A2) and 10.07 g of a vinyl group-containing linear polydimethylsiloxane (manufactured by Wacker Chemie AG) having a viscosity of 1,000 mPa·s represented by Formula (W) as the component (a1) were stirred with the stirrer A for 5 minutes, thereby obtaining a mixture (II).

7.14 g of the obtained mixture (II) was added to the mixture (I), and stirring was performed with the stirrer A for 5 minutes, thereby obtaining a mixture (III).

Finally, the obtained mixture (III) was filtered through a nylon filter with 300 mesh to obtain a protective adhesive composition 1. Note that a viscosity of the protective adhesive composition 1 measured using a rotational viscometer was 9,900 mPa·s.

### [1-2] Preparation of Peeling Adhesive Composition

### [Preparation Example 2]

Into a 600 mL stirring vessel dedicated to a stirrer A, 104.14 g of a p-menthane solution (concentration of 80.6 mass%) of an MQ resin (manufactured by Wacker Chemie AG) having a polysiloxane skeleton and a vinyl group as the component (a1), 58.11 g of a polyorganosiloxane represented by Formula (M1) (complex viscosity of 800 Pa·s, weight average molecular weight of 171,899 (dispersity of 2.18), manufactured by Wacker Chemie AG) as the component (B), and 34.94 g of p-menthane (manufactured by NIPPON TERPENE CHEMICALS, INC.) and 6.20 g of n-decane (manufactured by SANKYO CHEMICAL CO., LTD.) as solvents were added, and stirring was performed with the stirrer A for 5 minutes, thereby obtaining a mixture (I).

16.79 g of a SiH group-containing linear polydimethylsiloxane (manufactured by Wacker Chemie AG) having a viscosity of 100 mPa·s as the component (a2) and 24.54 g of a vinyl group-containing linear polydimethylsiloxane (manufactured by Wacker Chemie AG) having a viscosity of 200 mPa·s represented by Formula (V) as the component (a1) were added to the obtained mixture (I), thereby obtaining a mixture (II).

1.61 g of 1,1-diphenyl-2-propyn-1-ol (manufactured by Tokyo Chemical Industry Co., Ltd.) and 1.61 g of 1-ethynyl-1-cyclohexanol (manufactured by Wacker Chemie AG) as the component (A3), and 3.23 g of p-menthane (manufactured by NIPPON TERPENE CHEMICALS, INC.) as a solvent were stirred with the stirrer A for 60 minutes, thereby obtaining a mixture (III).

1.29 g of the obtained mixture (III) was added to the mixture (II), and stirring was performed with the stirrer A for 5 minutes, thereby obtaining a mixture (IV).

0.65 g of a platinum catalyst (manufactured by Wacker Chemie AG) as the component (A2) and 19.37 g of a vinyl group-containing linear polydimethylsiloxane (manufactured by Wacker Chemie AG) having a viscosity of 1,000 mPa·s represented by Formula (W) as the component (a1) were stirred with the stirrer A for 5 minutes, thereby obtaining a mixture (V).

4.00 g of the obtained mixture (V) was added to the mixture (IV), and stirring was performed with the stirrer A for 5 minutes, thereby obtaining a mixture (VI).

Finally, the obtained mixture (VI) was filtered through a nylon filter with 300 mesh to obtain a peeling adhesive composition 1. Note that a viscosity of the obtained peeling adhesive composition 1 was 3,000 mPa·s.

### [Preparation Example 3]

Into a 600 mL stirring vessel dedicated to the stirrer A, 105.26 g of a p-menthane solution (concentration of 80.6 mass%) of an MQ resin (manufactured by Wacker Chemie AG) having a polysiloxane skeleton and a vinyl group as the component (a1), 35.24 g of a polyorganosiloxane represented by Formula (M1) (complex viscosity of 6,000 Pa·S, weight average molecular weight: 642,000 (dispersity: 2.6), manufactured by Wacker Chemie AG, trade name: GENIOPLAST GUM) as the component (B), 54.11 g of p-menthane (manufactured by NIPPON TERPENE CHEMICALS, INC.), and 8.35 g of n-decane (manufactured by SANKYO CHEMICAL CO.,LTD.) were added, and stirring by the stirrer A for 5 minutes was repeated 8 times in total with a small break, thereby obtaining a mixture (I).

16.97 g of a SiH group-containing linear polydimethylsiloxane (manufactured by Wacker Chemie AG) having a viscosity of 100 mPa·s as the component (a2) and 24.80 g of a vinyl group-containing linear polydimethylsiloxane (manufactured by Wacker Chemie AG) having a viscosity of 200 mPa·s as the component (a1) were added to the obtained mixture (I), thereby obtaining a mixture (II).

1.63 g of 1,1-diphenyl-2-propyn-1-ol (manufactured by Tokyo Chemical Industry Co., Ltd.) as the component (A3), 1.63 g of 1-ethynyl-1-cyclohexanol (manufactured by Wacker Chemie AG) as (A3), and 3.26 g of p-menthane (manufactured by NIPPON TERPENE CHEMICALS, INC.) were stirred with the stirrer A for 5 minutes, thereby obtaining a mixture (III).

1.31 g of the obtained mixture (III) was added to the mixture (II), and stirring was performed with the stirrer A for 5 minutes, thereby obtaining a mixture (IV).

0.26 g of a platinum catalyst (manufactured by Wacker Chemie AG) as the component (A2) and 19.58 g of a vinyl group-containing linear polydimethylsiloxane (manufactured by Wacker Chemie AG) having a viscosity of 1,000 mPa·s as the component (a1) were stirred with the stirrer A for 5 minutes, thereby obtaining a mixture (V).

3.97 g of the obtained mixture (V) was added to the mixture (IV), and stirring was performed with the stirrer A for 5 minutes, thereby obtaining a mixture (VI).

Finally, the obtained mixture (VI) was filtered through a nylon filter with 300 mesh to obtain a peeling adhesive composition 2. Note that a viscosity of the obtained peeling adhesive composition 2 was 3,900 mPa·s.

### [2] Evaluation of Adhesiveness and Peelability

### [Example 1-1]

The protective adhesive composition 1 obtained in Preparation Example 1 was applied to a 300 mm silicon wafer (thickness: 770 µm) as a device-side wafer by spin coating, and heating was performed at 200°C for 10 minutes, thereby forming a protective adhesive layer on a circuit surface of the wafer so that a thickness of the protective adhesive layer was about 32.5 µm.

Subsequently, the peeling adhesive composition 1 obtained in Preparation Example 2 was applied onto the protective adhesive layer by spin coating, and heating (pre-heating treatment) was performed at 120°C for 1.5 minutes, thereby forming a peeling adhesive coating layer on the protective adhesive layer so that a thickness of the peeling adhesive layer in the laminate was about 32.5 µm.

Thereafter, in a vacuum bonding device Y, a silicon wafer including the protective adhesive layer and the peeling adhesive coating layer and a 300 mm glass wafer (thickness: 700 µm) as a carrier-side wafer (support) were bonded to each other so as to interpose the protective adhesive layer and the peeling adhesive coating layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

### [Example 1-2]

The protective adhesive composition 1 obtained in Preparation Example 1 was applied to a 300 mm silicon wafer (thickness: 770 µm) as a device-side wafer by spin coating, and heating was performed at 200°C for 10 minutes, thereby forming a protective adhesive layer on a circuit surface of the wafer so that a thickness of the protective adhesive layer was about 32.5 µm.

Subsequently, the peeling adhesive composition 2 obtained in Preparation Example 3 was applied onto the protective adhesive layer by spin coating, and heating (pre-heating treatment) was performed at 120°C for 1.5 minutes, thereby forming a peeling adhesive coating layer on the protective adhesive layer so that a thickness of the peeling adhesive layer in the laminate was about 32.5 µm.

Thereafter, in a vacuum bonding device Y, a silicon wafer including the protective adhesive layer and the peeling adhesive coating layer and a 300 mm glass wafer (thickness: 700 µm) as a carrier-side wafer (support) were bonded to each other so as to interpose the protective adhesive layer and the peeling adhesive coating layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

### [Comparative Example 1-1]

The protective adhesive composition 1 obtained in Preparation Example 1 was applied to a 300 mm silicon wafer (thickness: 770 µm) as a device-side wafer by spin coating, thereby forming a protective adhesive coating layer on a circuit surface of the wafer so that a thickness of the protective adhesive layer in the laminate was about 65 µm.

Thereafter, in a vacuum bonding device Y, a silicon wafer including the protective adhesive coating layer and a 300 mm glass wafer (thickness: 700 µm) as a carrier-side wafer (support) were bonded to each other so as to interpose the protective adhesive coating layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

### [Comparative Example 1-2]

The peeling adhesive composition 1 obtained in Preparation Example 2 was applied to a 300 mm silicon wafer (thickness: 770 µm) as a device-side wafer by spin coating, and heating (pre-heating treatment) was performed at 120°C for 1.5 minutes, thereby forming a peeling adhesive coating layer on a circuit surface of the wafer so that a thickness of the peeling adhesive layer in the laminate was about 65 µm.

Thereafter, in a vacuum bonding device Y, a silicon wafer including the peeling adhesive coating layer and a 300 mm glass wafer (thickness: 700 µm) as a carrier-side wafer (support) were bonded to each other so as to interpose the peeling adhesive coating layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

### [Comparative Example 1-3]

The peeling adhesive composition 2 obtained in Preparation Example 3 was applied to a 300 mm silicon wafer (thickness: 770 µm) as a device-side wafer by spin coating, and heating (pre-heating treatment) was performed at 120°C for 1.5 minutes, thereby forming a peeling adhesive coating layer on a circuit surface of the wafer so that a thickness of the peeling adhesive layer in the laminate was about 65 µm.

Thereafter, in a vacuum bonding device Y, a silicon wafer including the peeling adhesive coating layer and a 300 mm glass wafer (thickness: 700 µm) as a carrier-side wafer (support) were bonded to each other so as to interpose the adhesive layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

Using the laminates obtained in Example 1-1, Example 1-2, Comparative Example 1-1, Comparative Example 1-2, and Comparative Example 1-3, the adhesiveness and peelability of the adhesive layer in each laminate were evaluated.

The adhesiveness was evaluated by visually confirming the presence or absence of voids from the glass wafer (support) side of the laminate. In a case where no voids were confirmed, the adhesiveness was evaluated as good, and in a case where voids were confirmed, the adhesiveness was evaluated as poor. Here, the void means a state in which there are bubbles between the substrate and the layer, between the two layers, or in the layer of the laminate, and in such a state in which there are undesirable bubbles, sufficient protection of the semiconductor substrate cannot be expected.

In the evaluation of the peelability, the force required for peeling the semiconductor substrate and the support substrate was measured, and a case where peeling could be performed by the peeling device X was evaluated as good, and a case where peeling could not be performed was evaluated as poor.

As a result, no voids were confirmed in all the laminates. As for the peelability, in Example 1-1 and Example 1-2, the semiconductor substrate and the support substrate could be preferably peeled off with a force of 15 N. In addition, it was found that Comparative Example 1-1 could not be peeled off by the peeling device X. Note that, in Comparative Example 1-2 and Comparative Example 1-3, peeling was possible with a force of 15 N.

As described above, it was found that the laminate of the present invention exhibited excellent peelability by including a peeling adhesive layer even in the presence of the non-peelable protective adhesive composition 1.

### [3-1] Confirmation of Bump Protection Performance

### [Example 2-1]

The protective adhesive composition 1 obtained in Preparation Example 1 was applied to a PI TEG 4 x 4 cm chip (thickness: 770 µm, bump diameter: 0.03 mm, bump height: 0.04 mm, bump pitch: 0.06 × 0.1 mm) as a device-side substrate by spin coating, and heating was performed at 200°C for 10 minutes, thereby forming a protective adhesive layer on a circuit surface of the chip so that a thickness of the protective adhesive layer was about 32.5 µm.

Subsequently, the peeling adhesive composition 1 obtained in Preparation Example 2 was applied onto the protective adhesive layer by spin coating, and heating (pre-heating treatment) was performed at 120°C for 1.5 minutes, thereby forming a peeling adhesive coating layer so that a thickness of the peeling adhesive layer in the laminate was about 32.5 µm.

Thereafter, in a vacuum bonding device X, a chip including the protective adhesive layer and the peeling adhesive coating layer and a 100 mm glass wafer (thickness: 770 µm) as a carrier-side wafer (support) were bonded to each other so as to interpose the protective adhesive layer and the peeling adhesive coating layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

### [Example 2-2] to [Example 2-8]

Laminates of Examples 2-2 to 2-8 were obtained in the same method as that of Example 2-1, except that the type of each adhesive composition and the film thickness of each layer in Example 2-1 were changed as shown in Table 1.

### [Comparative Example 2-1]

The peeling adhesive composition 1 obtained in Preparation Example 2 was applied to a PI TEG 4 x 4 cm chip (thickness: 770 µm, bump diameter: 0.03 mm, bump height: 0.04 mm, bump pitch: 0.06 × 0.1 mm) as a device-side substrate by spin coating, and heating (pre-heating treatment) was performed at 120°C for 1.5 minutes, thereby forming a peeling adhesive coating layer on the chip so that a thickness of the peeling adhesive layer in the laminate was about 65 µm.

Thereafter, in a vacuum bonding device X, a chip including the peeling adhesive coating layer and a 100 mm glass wafer (thickness: 770 µm) as a carrier-side wafer (support) were bonded to each other so as to interpose the peeling adhesive coating layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

### [Comparative Example 2-2]

The peeling adhesive composition 2 obtained in Preparation Example 3 was applied to a PI TEG 4 x 4 cm chip (thickness: 770 µm, bump diameter: 0.03 mm, bump height: 0.04 mm, bump pitch: 0.06 × 0.1 mm) as a device-side substrate by spin coating, and heating (pre-heating treatment) was performed at 120°C for 1.5 minutes, thereby forming a peeling adhesive coating layer on the chip so that a thickness of the peeling adhesive layer in the laminate was about 65 µm.

Thereafter, in a vacuum bonding device X, a chip including the peeling adhesive coating layer and a 100 mm glass wafer (thickness: 770 µm) as a carrier-side wafer (support) were bonded to each other so as to interpose the peeling adhesive coating layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

### [Comparative Example 2-3]

The protective adhesive composition 1 obtained in Preparation Example 1 was applied to a PI TEG 4 x 4 cm chip (thickness: 770 µm, bump diameter: 0.03 mm, bump height: 0.04 mm, bump pitch: 0.06 × 0.1 mm) as a device-side substrate by spin coating, thereby forming a protective adhesive coating layer on the chip so that a thickness of the protective adhesive layer in the laminate was about 65 µm.

Thereafter, in a vacuum bonding device X, a chip including the adhesive layer and a 100 mm glass wafer (thickness: 770 µm) as a carrier-side wafer (support) were bonded to each other so as to interpose the adhesive layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

### [Comparative Example 2-4]

The peeling adhesive composition 1 obtained in Preparation Example 2 was applied to a PI TEG 4 x 4 cm chip (thickness: 770 µm, bump diameter: 0.03 mm, bump height: 0.04 mm, bump pitch: 0.06 × 0.1 mm) as a device-side substrate by spin coating, heating (pre-heating treatment) was performed at 120°C for 1.5 minutes to remove a residual solvent on the chip, and heating was further performed at 200°C for 10 minutes, thereby forming a peeling adhesive coating layer on the chip so that a thickness of the peeling adhesive layer in the laminate was about 32.5 µm.

Subsequently, the protective adhesive composition 1 obtained in Preparation Example 1 was applied onto the peeling adhesive coating layer by spin coating, thereby forming a protective adhesive coating layer on the peeling adhesive coating layer so that a thickness of the protective adhesive layer in the laminate was about 32.5 µm.

Thereafter, in a vacuum bonding device X, a chip including the peeling adhesive coating layer and the protective adhesive coating layer and a 100 mm glass wafer (thickness: 770 µm) as a carrier-side wafer (support) were bonded to each other so as to interpose the peeling adhesive coating layer and the protective adhesive coating layer therebetween, and heating (post-heating treatment) was performed on a hot plate with the device-side wafer facing down at 200°C for 10 minutes, thereby manufacturing a laminate. Note that bonding was performed under a load of 30 N at a temperature of 23°C and a degree of reduced pressure of 1,000 Pa.

### [3-2] Evaluation of High-Temperature Treatment

Using a hot plate, each of the laminates obtained in Example 2-1, Example, 2-2, Example 2-3, Example 2-4, Example 2-5, Example 2-6, Example 2-7, Example 2-8, Comparative Example 2-1, Comparative Example 2-2, Comparative Example 2-3, and Comparative Example 2-4 was subjected to a high-temperature treatment. The high-temperature treatment was performed on the day of preparation (before preparation) and 10 days after the preparation (after preparation) for each laminate. The high-temperature treatment was performed according to the following procedure.

A glass wafer (support substrate) of the laminate was placed on the hot plate set at 270°C with the glass wafer facing down, and heating was performed for 5 minutes.

The state of the silicon wafer as the semiconductor substrate of each laminate after the treatment was observed through the glass wafer as a support substrate using an optical microscope, and the presence or absence of bump deformation was visually confirmed.

The number of bumps in one laminate was 5,044, a case where the number of deformed bumps was 0 or more and less than 50 was determined as ∘, a case where the number of deformed bumps was 50 or more and less than 100 was determined as △, and a case where the number of deformed bumps was 100 or more was determined as ×.

The results are shown in Table 1. In Table 1, the number in parentheses indicates the film thickness of each layer.

**[Table 1]**

| | Device side (semiconductor substrate side) | Carrier side (support substrate side) | Bump deformation (before manufacturing) | Bump deformation (after manufacturing) |
|---|---|---|---|---|
| Example 2-1 | Protective adhesive composition 1 (32.5 µm) | Peeling adhesive composition 1 (32.5 µm) | ○ | Δ |
| Example 2-2 | Protective adhesive composition 1 (32.5 µm) | Peeling adhesive composition 2 (32.5 µm) | ○ | Δ |
| Example 2-3 | Protective adhesive composition 1 (40 µm) | Peeling adhesive composition 1 (25 µm) | ○ | ○ |
| Example 2-4 | Protective adhesive composition 1 (40 µm) | Peeling adhesive composition 2 (25 µm) | ○ | ○ |
| Example 2-5 | Protective adhesive composition 1 (32.5 µm) | Peeling adhesive composition 1 (65 µm) | ○ | ○ |
| Example 2-6 | Protective adhesive composition 1 (32.5 µm) | Peeling adhesive composition 2 (65 µm) | ○ | ○ |
| Example 2-7 | Protective adhesive composition 1 (40 µm) | Peeling adhesive composition 1 (65 µm) | ○ | ○ |
| Example 2-8 | Protective adhesive composition 1 (40 µm) | Peeling adhesive composition 2 (65 µm) | ○ | ○ |
| Comparative Example 2-1 | Peeling adhesive composition 1 (65 µm) | | ○ | × |
| Comparative Example 2-2 | Peeling adhesive composition 2 (65 µm) | | ○ | × |
| Comparative Example 2-3 | Protective adhesive composition 1 (65 µm) | | ○ | Δ |
| Comparative Example 2-4 | Peeling adhesive composition 1 (32.5 µm) | Protective adhesive composition 1 (32.5 µm) | × | × |

As shown in the results of Table 1, the laminates obtained in Example 2-1 to Example 2-8 had an excellent bump protection performance. In particular, the laminate had the excellent bump protection performance even after manufacturing.

On the other hand, in the laminates of Comparative Example 2-1, Comparative Example 2-2, and Comparative Example 2-4, a large number of bump deformations were confirmed after manufacturing.

From the results of Examples, it was found that the laminate of the present invention was a laminate having an excellent bump protection performance capable of easily peeling the semiconductor substrate and the support substrate and suppressing deformation of the bump.

### Industrial Applicability

According to the present invention, it is possible to provide a laminate that can easily peel the semiconductor substrate and the support substrate and can suppress deformation of a bump, and thus is useful for manufacturing a processed semiconductor substrate.

### Reference Signs List

- 1: Wafer
- 1a: Bump
- 2: Protective adhesive layer
- 2a: Protective adhesive coating layer
- 3: Peeling adhesive layer
- 3a: Peeling adhesive coating layer
- 4: Support substrate
- 11: Coating device
- 12: Heating device
- 13: Coating device
- 14: Heating device

## Claims

1. A laminate comprising: a semiconductor substrate (1) with a bump (1a); a support substrate (4); a protective adhesive layer (2) formed so as to be in contact with the semiconductor substrate (1) with a bump (1a); and a peeling adhesive layer (3) formed between the protective adhesive layer (2) and the support substrate (4),
wherein the protective adhesive layer (2) is formed of a protective adhesive composition, and the protective adhesive composition contains a component (A) which is cured by a hydrosilylation reaction and does not contain a peeling agent component (B) which does not cause a curing reaction together with the component (A),
the peeling adhesive layer (3) is formed of a peeling adhesive composition, and the peeling adhesive composition contains a component (A) which is cured by a hydrosilylation reaction and a peeling agent component (B) which does not cause a curing reaction together with the component (A),
the component (A) contained in the protective adhesive composition contains a polyorganosiloxane (a1) containing an alkenyl group having 2 to 40 carbon atoms bonded to silicon atoms, a polyorganosiloxane (a2) containing a Si-H group, and a platinum group metal-based catalyst (A2),
the component (A) contained in the peeling adhesive composition contains a polyorganosiloxane (a1) containing an alkenyl group having 2 to 40 carbon atoms bonded to silicon atoms, a polyorganosiloxane (a2) containing a Si-H group, and a platinum group metal-based catalyst (A2), and
the peeling agent component (B) contained in the peeling adhesive composition is a polyorganosiloxane selected from an epoxy group-containing polyorganosiloxane, a methyl group-containing polyorganosiloxane, and a phenyl group-containing polyorganosiloxane.

2. The laminate according to claim 1, wherein the peeling agent component (B) contained in the peeling adhesive composition includes a polydimethylsiloxane which is selected from an epoxy group-containing polydimethylsiloxane, an unmodified polydimethylsiloxane, and a phenyl group-containing polydimethylsiloxane.

3. A method for manufacturing a semiconductor substrate (1), the method comprising:
a step of processing the semiconductor substrate in the laminate according to claim 1 or 2; and
a step of separating the support substrate (4) and the processed semiconductor substrate (1) by separating the protective adhesive layer (2) and the peeling adhesive layer (3).

4. The method for manufacturing a semiconductor substrate (1) according to claim 3, wherein the processing step includes polishing a surface of the semiconductor substrate (1) opposite to a surface on which the bump (1a) exists to thin the semiconductor substrate (1).

5. A method for manufacturing the laminate according to claim 1 or 2, the method comprising:
a protective adhesive coating layer formation step of forming a protective adhesive coating layer (2a) by applying a protective adhesive composition onto a surface of the semiconductor substrate (1) on which the bump (1a) exists;
a protective adhesive layer formation step of forming the protective adhesive layer (2) by heating the protective adhesive coating layer (2a);
a peeling adhesive coating layer formation step of forming a peeling adhesive coating layer (3a) by applying a peeling adhesive composition onto the support substrate (4) or applying the peeling adhesive composition onto the protective adhesive layer (2); and
a peeling adhesive layer formation step of forming the peeling adhesive layer (3) by heating the peeling adhesive coating layer (3a) in a state in which the peeling adhesive coating layer (3a) and the protective adhesive layer (2) are in contact with each other and the peeling adhesive coating layer (3a) and the support substrate (4) are in contact with each other, wherein
the protective adhesive composition contains a component (A) which is cured by a hydrosilylation reaction and does not contain a peeling agent component (B) which does not cause a curing reaction together with the component (A),
the peeling adhesive composition contains a component (A) which is cured by a hydrosilylation reaction and a peeling agent component (B) which does not cause a curing reaction together with the component (A),
the component (A) contained in the protective adhesive composition contains a polyorganosiloxane (a1) containing an alkenyl group having 2 to 40 carbon atoms bonded to silicon atoms, a polyorganosiloxane (a2) containing a Si-H group, and a platinum group metal-based catalyst (A2),
the component (A) contained in the peeling adhesive composition contains a polyorganosiloxane (a1) containing an alkenyl group having 2 to 40 carbon atoms bonded to silicon atoms, a polyorganosiloxane (a2) containing a Si-H group, and a platinum group metal-based catalyst (A2), and
the peeling agent component (B) contained in the peeling adhesive composition is a polyorganosiloxane selected from an epoxy group-containing polyorganosiloxane, a methyl group-containing polyorganosiloxane, and a phenyl group-containing polyorganosiloxane.

## Patentansprüche

1. Laminat, umfassend: ein Halbleitersubstrat (1) mit einem Bump (1a); ein Trägersubstrat (4); eine Schutzklebeschicht (2), die so ausgebildet ist, dass sie mit dem Halbleitersubstrat (1) mit einem Bump (1a) in Kontakt steht; und eine Ablöseklebeschicht (3), die zwischen der Schutzklebeschicht (2) und dem Trägersubstrat (4) ausgebildet ist,
wobei die Schutzklebeschicht (2) aus einer Schutzklebstoffzusammensetzung gebildet ist und die Schutzklebstoffzusammensetzung eine Komponente (A) enthält, die durch eine Hydrosilylierungsreaktion gehärtet wird, und nicht eine Ablösemittelkomponente (B) enthält, die keine Härtungsreaktion zusammen mit der Komponente (A) eingeht,
wobei die Ablöseklebeschicht (3) aus einer Ablöseklebstoffzusammensetzung gebildet ist und die Ablöseklebstoffzusammensetzung eine Komponente (A) enthält, die durch eine Hydrosilylierungsreaktion gehärtet wird, und eine Ablösemittelkomponente (B) enthält, die keine Härtungsreaktion zusammen mit der Komponente (A) eingeht,
die in der Schutzklebstoffzusammensetzung enthaltene Komponente (A) ein Polyorganosiloxan (a1), enthaltend eine Alkenylgruppe mit 2 bis 40 Kohlenstoffatomen, gebunden an Siliciumatome, ein Polyorganosiloxan (a2), enthaltend eine Si-H-Gruppe, und einen Katalysator (A2) auf Basis eines Metalls der Platingruppe enthält,
die in der Ablöseklebstoffzusammensetzung enthaltene Komponente (A) ein Polyorganosiloxan (a1), enthaltend eine Alkenylgruppe mit 2 bis 40 Kohlenstoffatomen, gebunden an Siliciumatome, ein Polyorganosiloxan (a2), enthaltend eine Si-H-Gruppe, und einen Katalysator (A2) auf Basis eines Metalls der Platingruppe enthält, und
die in der Ablöseklebstoffzusammensetzung enthaltene Ablösemittelkomponente (B) ein Polyorganosiloxan ist, das aus einem epoxidgruppenhaltigen Polyorganosiloxan, einem methylgruppenhaltigen Polyorganosiloxan und einem phenylgruppenhaltigen Polyorganosiloxan ausgewählt ist.

2. Laminat gemäß Anspruch 1, wobei die in der Ablöseklebstoffzusammensetzung enthaltene Ablösemittelkomponente (B) ein Polydimethylsiloxan umfasst, das aus einem epoxidgruppenhaltigen Polydimethylsiloxan, einem unmodifizierten Polydimethylsiloxan und einem phenylgruppenhaltigen Polydimethylsiloxan ausgewählt ist.

3. Verfahren zur Herstellung eines Halbleitersubstrats (1), wobei das Verfahren umfasst:
einen Schritt des Bearbeitens des Halbleitersubstrats in dem Laminat gemäß Anspruch 1 oder 2; und
einen Schritt des Trennens des Trägersubstrats (4) und des bearbeiteten Halbleitersubstrats (1) durch Trennen der Schutzklebeschicht (2) und der Ablöseklebeschicht (3) .

4. Verfahren zur Herstellung eines Halbleitersubstrats (1) gemäß Anspruch 3, wobei der Bearbeitungsschritt das Polieren einer Oberfläche des Halbleitersubstrats (1) gegenüber einer Oberfläche, auf der sich der Bump (1a) befindet, umfasst, um das Halbleitersubstrat (1) zu verdünnen.

5. Verfahren zur Herstellung des Laminats gemäß Anspruch 1 oder 2, wobei das Verfahren umfasst:
einen Schutzklebstoffbeschichtungsschicht-Bildungsschritt des Bildens einer Schutzklebstoffbeschichtungsschicht (2a) durch Aufbringen einer Schutzklebstoffzusammensetzung auf eine Oberfläche des Halbleitersubstrats (1), auf der sich der Bump (1a) befindet;
einen Schutzklebeschicht-Bildungsschritt des Bildens der Schutzklebeschicht (2) durch Erhitzen der Schutzklebstoffbeschichtungsschicht (2a);
einen Ablöseklebstoffbeschichtungsschicht-Bildungsschritt des Bildens einer Ablöseklebstoffbeschichtungsschicht (3a) durch Aufbringen einer Ablöseklebstoffzusammensetzung auf das Trägersubstrat (4) oder durch Aufbringen der Ablöseklebstoffzusammensetzung auf die Schutzklebeschicht (2); und
einen Ablöseklebeschicht-Bildungsschritt des Bildens der Ablöseklebeschicht (3) durch Erhitzen der Ablöseklebstoffbeschichtungsschicht (3a) in einem Zustand, in dem die Ablöseklebestoffbeschichtungsschicht (3a) und die Schutzklebeschicht (2) miteinander in Kontakt stehen und die Ablöseklebestoffbeschichtungsschicht (3a) und das Trägersubstrat (4) miteinander in Kontakt stehen, wobei
die Schutzklebstoffzusammensetzung eine Komponente (A) enthält, die durch eine Hydrosilylierungsreaktion gehärtet wird, und nicht eine Ablösemittelkomponente (B) enthält, die keine Härtungsreaktion zusammen mit der Komponente (A) eingeht,
die Ablöseklebstoffzusammensetzung eine Komponente (A) enthält, die durch eine Hydrosilylierungsreaktion gehärtet wird, und eine Ablösemittelkomponente (B) enthält, die keine Härtungsreaktion zusammen mit der Komponente (A) eingeht,
die in der Schutzklebstoffzusammensetzung enthaltene Komponente (A) ein Polyorganosiloxan (a1), enthaltend eine Alkenylgruppe mit 2 bis 40 Kohlenstoffatomen, gebunden an Siliciumatome, ein Polyorganosiloxan (a2), enthaltend eine Si-H-Gruppe, und einen Katalysator (A2) auf Basis eines Metalls der Platingruppe enthält,
die in der Ablöseklebstoffzusammensetzung enthaltene Komponente (A) ein Polyorganosiloxan (a1), enthaltend eine Alkenylgruppe mit 2 bis 40 Kohlenstoffatomen, gebunden an Siliciumatome, ein Polyorganosiloxan (a2), enthaltend eine Si-H-Gruppe, und einen Katalysator (A2) auf Basis eines Metalls der Platingruppe enthält, und
die in der Ablöseklebstoffzusammensetzung enthaltene Ablösemittelkomponente (B) ein Polyorganosiloxan ist, das aus einem epoxidgruppenhaltigen Polyorganosiloxan, einem methylgruppenhaltigen Polyorganosiloxan und einem phenylgruppenhaltigen Polyorganosiloxan ausgewählt ist.

## Revendications

1. Corps multicouche comprenant : un substrat (1) semi-conducteur avec une bosse (1a) ; un substrat (4) de support ; une couche (2) de liaison pour la protection formée pour être en contact avec le substrat (1) semi-conducteur avec une bosse (1a) ; et une couche (3) de liaison pour la séparation formée entre la couche (2) de liaison pour la protection et le substrat (4) de support,
dans lequel la couche (2) de liaison pour la protection est formée d'une composition adhésive pour la protection, et la composition adhésive pour la protection contient un composant (A) qui est durci par une réaction d'hydrosilylation et ne contient pas de composant (B) d'agent d'élimination qui ne provoque pas une réaction de durcissement conjointement avec le composant (A),
la couche (3) de liaison pour la séparation est formée d'une composition adhésive pour la séparation, et la composition adhésive pour la séparation contient un composant (A) qui est durci par une réaction d'hydrosilylation et un composant (B) d'agent d'élimination qui ne provoque pas une réaction de durcissement conjointement avec le composant (A),
le composant (A) contenu dans la composition adhésive pour la protection contient un polyorganosiloxane (a1) contenant un groupe alcényl présentant 2 à 40 atomes de carbone liés à des atomes de silicium, un polyorganosiloxane (a2) contenant un groupe Si-H, et un catalyseur (A2) à base d'un métal du groupe du platine,
le composant (A) contenu dans la composition adhésive pour la séparation contient un polyorganosiloxane (a1) contenant un groupe alcényl présentant 2 à 40 atomes de carbone liés à des atomes de silicium, un polyorganosiloxane (a2) contenant un groupe Si-H, et un catalyseur (A2) à base d'un métal du groupe du platine, et
le composant (B) d'agent d'élimination contenu dans la composition adhésive pour la séparation est un polyorganosiloxane sélectionné parmi un polyorganosiloxane qui contient un groupe époxy, un polyorganosiloxane qui contient un groupe méthyl et un polyorganosiloxane qui contient un groupe phényl.

2. Corps multicouche selon la revendication 1, dans lequel le composant (B) d'agent d'élimination contenu dans la composition adhésive pour la séparation inclut un polydiméthylsiloxane qui est sélectionné parmi un polydiméthylsiloxane qui contient un groupe époxy, un polydiméthylsiloxane non modifié et un polydiméthylsiloxane qui contient un groupe phényl.

3. Procédé de fabrication d'un substrat (1) semi-conducteur, le procédé comprenant :
une étape consistant à traiter le substrat semi-conducteur dans le corps multicouche selon la revendication 1 ou la revendication 2 ; et
une étape consistant à séparer le substrat (4) de support et le substrat (1) semi-conducteur traité en séparant la couche (2) de liaison pour la protection et la couche (3) de liaison pour la séparation.

4. Procédé de fabrication d'un substrat (1) semi-conducteur selon la revendication 3, dans lequel l'étape de traitement inclut le polissage d'une surface du substrat (1) semi-conducteur opposée à une surface sur laquelle la bosse (1a) existe pour amincir le substrat (1) semi-conducteur.

5. Procédé de fabrication du corps multicouche selon la revendication 1 ou la revendication 2, le procédé comprenant :
une étape de formation de couche de revêtement de liaison pour la protection consistant à former une couche (2a) de revêtement de liaison pour la protection en appliquant une composition adhésive pour la protection sur une surface du substrat (1) semi-conducteur sur laquelle la bosse (1a) existe ;
une étape de formation de la couche de liaison pour la protection consistant à former la couche (2) de liaison pour la protection par chauffage de la couche (2a) de revêtement de liaison pour la protection ;
une étape de formation de couche de revêtement de liaison pour la séparation consistant à former une couche (3a) de revêtement de liaison pour la séparation en appliquant une composition adhésive pour la séparation sur le substrat (4) de support ou en appliquant la composition adhésive pour la séparation sur la couche (2) de liaison pour la protection ; et
une étape de formation de la couche de liaison pour la séparation consistant à former la couche (3) de liaison pour la séparation par chauffage de la couche (3a) de revêtement de liaison de séparation dans un état où la couche (3a) de revêtement de liaison pour la séparation et la couche (2) de liaison pour la protection sont en contact l'une avec l'autre et la couche (3a) de revêtement de liaison de séparation et le substrat (4) de support sont en contact l'un avec l'autre, dans lequel
la composition adhésive pour la protection contient un composant (A) qui est durci par une réaction d'hydrosilylation et ne contient pas de composant (B) d'agent d'élimination qui ne provoque pas une réaction de durcissement conjointement avec le composant (A),
la composition adhésive pour la séparation contient un composant (A) qui est durci par une réaction d'hydrosilylation et un composant (B) d'agent d'élimination qui ne provoque pas une réaction de durcissement conjointement avec le composant (A),
le composant (A) contenu dans la composition adhésive pour la protection contient un polyorganosiloxane (a1) contenant un groupe alcényl présentant 2 à 40 atomes de carbone liés à des atomes de silicium, un polyorganosiloxane (a2) contenant un groupe Si-H, et un catalyseur (A2) à base d'un métal du groupe du platine,
le composant (A) contenu dans la composition adhésive pour la séparation contient un polyorganosiloxane (a1) contenant un groupe alcényl présentant 2 à 40 atomes de carbone liés à des atomes de silicium, un polyorganosiloxane (a2) contenant un groupe Si-H, et un catalyseur (A2) à base d'un métal du groupe du platine, et
le composant (B) d'agent d'élimination contenu dans la composition adhésive pour la séparation est un polyorganosiloxane sélectionné parmi un polyorganosiloxane qui contient un groupe époxy, un polyorganosiloxane qui contient un groupe méthyl et un polyorganosiloxane qui contient un groupe phényl.
